(19)

**Europäisches Patentamt**
**European Patent Office**
**Office européen des brevets**

(11) **EP 4 579 438 A1**

(12) **EUROPEAN PATENT APPLICATION**

(43) Date of publication:
**02.07.2025 Bulletin 2025/27**

(51) International Patent Classification (IPC):
**G06F 7/544** *(2006.01)*

(21) Application number: **24198624.9**

(22) Date of filing: **05.09.2024**

(52) Cooperative Patent Classification (CPC):
**G06F 7/5443**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.12.2023 US 202363615787 P**
**01.08.2024 US 202418792368**

(71) Applicant: **Macronix International Co., Ltd.**
**Hsin-chu (TW)**

(72) Inventor: **Hung, Chun-Hsiung**
**Hsin-Chu, Taiwan (TW)**

(74) Representative: **Kurig, Thomas**
**Becker Kurig & Partner**
**Patentanwälte mbB**
**Bavariastraße 7**
**80336 München (DE)**

(54) **COMPUTE-IN-MEMORY CIRCUIT AND METHOD OF PERFORMING OPERATIONS THEREOF**

(57)     A compute-in-memory circuit is provided. The circuit includes one or more input lines receiving M input data elements, M being greater than zero, an array of memory cells including one or more subgroups, each subgroup of the one or more subgroups storing M stored data elements, multiplier circuits connected to the array of memory cells and to the one or more input lines, and configured to multiply the M input data elements by the M stored data elements in a selected subgroup of the one or more subgroups and configured to provide a multiplier output having M data elements, and accumulation circuitry including an accumulator input of M data elements connected to the multiplier output and configured to generate a sum of the M data elements of the multiplier output, wherein the multiplier circuits supply a multiplication result to the multiplier output from subgroups.

100

FIG. 1

EP 4 579 438 A1

## Description

BACKGROUND

Field of the Invention

The present invention relates to circuitry usable to perform in-memory or near-memory computation, such as multiply-and-accumulate (MAC) or other sum-of-products like operations.

Description of Related Art

In neuromorphic computing systems, machine learning systems and circuitry used for some types of computations based on linear algebra, the multiply-and-accumulate or sum-of-products functions can be important components. Such functions can be expressed as follows:

$$f(X_i) = \sum_{i=1}^{M} W_i X_i$$

In this expression, each product term is a product of a variable input $X_i$ and a weight Wi. The weight $W_i$ can vary among the terms, corresponding for example to coefficients of the variable inputs $X_i$.

The sum-of-products function can be realized as a circuit operation using crosspoint array architectures in which the electrical characteristics of cells of the array effectuate the function.

These architectures can be implemented in digital computing-in-memory (dCIM) systems and as digital near-memory-computing (dNMC) systems to carry out multiply and accumulate (MAC) operations, as described in the formula above. Conventionally, in these systems, one product subgroup is accompanied by a corresponding adder tree (e.g., an accumulator). As a result, there are many adder trees, because each subgroup (of a larger group) has its own corresponding adder tree. Adder trees have a relatively large layout area and are therefore expensive with respect to space. Conventionally, in these systems, the adder-trees occupy an undesirable amount of space. Hereinafter, for the sake of brevity, the term dCIM systems also encompasses dNMC systems.

Additionally, in these dCIM systems, the time that it takes to download memory content (e.g., the weights) is undesirably long, as a result of the necessity to toggle several or all word lines (WLs), which results in slower performance. Specifically, in dCIM systems, during the downloading of the contents (e.g., the weights), the multiplication operations of several subgroups have to be stopped, which degrades performance.

Therefore, it is desirable to provide dCIM systems that have a reduced number of adder trees and that are capable of performing MAC operations, or the like, while also downloading new contents (e.g., weights).

SUMMARY

In an embodiment, a compute-in-memory circuit is provided. The compute-in-memory circuit can include one or more input lines receiving M input data elements, M being an integer greater than zero, an array of memory cells including a one or more subgroups, each subgroup of the one or more subgroups storing M stored data elements, multiplier circuits connected to the array of memory cells and to the one or more input lines, and configured to multiply the M input data elements by the M stored data elements in a selected subgroup of the one or more subgroups and configured to provide a multiplier output having M data elements, and accumulation circuitry including an accumulator input of M data elements connected to the multiplier output and configured to generate a sum of the M data elements of the multiplier output, wherein the multiplier circuits supply a multiplication result to the multiplier output from the one or more subgroups (in sequence).

In a further embodiment, the multiplier circuits can include, for each subgroup of the one or more subgroups, M tri-state multipliers connected to the multiplier output.

In another embodiment, the M tri-state multipliers can be M tri-state NOR gates.

In an embodiment, the one or more subgroups can include a first subgroup storing M stored data elements and a second subgroup storing M stored data elements, wherein the M tri-state multipliers for the first subgroup are enabled by a first timing signal to multiply the M input data elements by the M stored data elements of the first subgroup, and wherein the M tri-state multipliers for the second subgroup are enabled by a second timing signal to multiply the M input data elements by the M stored data elements of the second subgroup, such that the M tri-state multipliers for the second subgroup are enabled at a time that is different than the M tri-state multipliers for the first subgroup, the second timing signal being provided at a time that is different than the first timing signal.

In a further embodiment, the one or more subgroups can include a first subgroup storing M stored data elements in M storage circuits and a second subgroup storing M stored data elements in M storage circuits, wherein the first subgroup is connected to a first word line, and wherein the second subgroup is connected to a second word line.

In another embodiment, a particular storage circuit of the M storage circuits of the first subgroup and a particular storage circuit of the M storage circuits of the second subgroup can share common lines for controlling storing of respective data elements, wherein the particular storage circuit of the first subgroup stores a particular data element in dependence on the first word line activating the first subgroup, and wherein the particular storage circuit of the second subgroup stores a particular data element in dependence on the second word line activating the second subgroup.

In an embodiment, the common lines shared by the particular storage circuit of the first subgroup and the particular storage circuit of the second subgroup can include a bit line (BL).

In a further embodiment, a particular storage circuit of the M storage circuits of the second subgroup can have a particular data element written thereto while, at least one of, (i) the M tri-state multipliers for the first subgroup are enabled by a first timing signal to multiply the M input data elements by the M stored data elements of the first subgroup to provide the multiplier output having M data elements and (ii) the accumulation circuitry receives and accumulates the multiplier output having M data elements.

In another embodiment, the multiplier output can include a first output line and a second output line, wherein the first output line is shared by an output of one tri-state multiplier for the first subgroup and an output of one tri-state multiplier for the second subgroup, wherein the second output line is shared by an output of another tri-state multiplier for the first subgroup and an output of another tri-state multiplier for the second subgroup, wherein outputs associated with the first subgroup are provided to the accumulation circuitry via the first and second output lines in dependence upon the M tri-state multipliers for the first subgroup being enabled by timing control signals without the M tri-state multipliers for the second subgroup being enabled by the timing control signals, and wherein outputs associated with the second subgroup are provided to the accumulation circuitry via the first and second output lines in dependence upon the M tri-state multipliers for the second subgroup being enabled by the timing control signals without the M tri-state multipliers for the first subgroup being enabled by the timing control signals.

In an embodiment, the one or more subgroups can include a first subgroup storing M stored data elements, a second subgroup storing M stored data elements, a third subgroup storing M stored data elements and a fourth subgroup storing M stored data elements, wherein the first subgroup and the second subgroup are connected to a first word line, wherein the third subgroup and the fourth subgroup are connected to a second word line, wherein the M tri-state multipliers for the first subgroup are enabled by a first timing signal to multiply the M input data elements by the M stored data elements of the first subgroup, wherein the M tri-state multipliers for the second subgroup are enabled by a second timing signal to multiply the M input data elements by the M stored data elements of the second subgroup, wherein the M tri-state multipliers for the third subgroup are enabled by a third timing signal to multiply the M input data elements by the M stored data elements of the third subgroup, and wherein the M tri-state multipliers for the fourth subgroup are enabled by a fourth timing signal to multiply the M input data elements by the M stored data elements of the fourth subgroup, and wherein L is an integer that can represent a total number of the M stored data elements of the first subgroup and M stored data elements of the second subgroup and wherein $M = L/2$.

In another embodiment, the multiplier output can include a first output line, wherein the first output line is shared by an output of one tri-state multiplier for the first subgroup, an output of one tri-state multiplier for the second subgroup, an output of one tri-state multiplier for the third subgroup and an output of one tri-state multiplier for the fourth subgroup.

In an embodiment, the multiplier output can include a second output line, and wherein the second output line is shared by an output of another tri-state multiplier for the first subgroup, an output of another tri-state multiplier for the second subgroup, an output of another tri-state multiplier for the third subgroup and an output of another tri-state multiplier for the fourth subgroup.

In a further embodiment, the M stored elements of each respective subgroup of the one or more subgroups can be written to each respective subgroup using bit lines.

In another embodiment, the M stored elements of each respective subgroup of the one or more subgroups can be written to each respective subgroup using sense amplifiers connected to bit lines.

In an embodiment, the one or more subgroups can include a first subgroup storing M stored data elements and a second subgroup storing M stored data elements, wherein, during a first clock cycle, the first subgroup multiplies the M stored data elements by the M input data elements and the second subgroup has the M stored elements written thereto, and wherein, during a second clock cycle, the second subgroup multiplies the M stored data elements by the M input data elements and the first subgroup has the M stored elements written thereto.

In a further embodiment, the one or more subgroups can include a first subgroup storing M stored data elements and a second subgroup storing M stored data elements, wherein, during a particular clock cycle, the accumulation circuitry accumulates outputs associated with the first subgroup, and wherein, during a subsequent clock cycle, the accumulation circuitry accumulates outputs associated with the second subgroup.

In another embodiment, the accumulation circuitry can be pipelined.

In an embodiment, the multiplier circuits can include, for each subgroup of the one or more subgroups, M pass gates connected to a shared M bit multiplier connected to the multiplier output.

In another embodiment the multiplier circuits can be enabled by timing control signals to supply the multiplication result. In an embodiment, the timing control signals can include a first timing signal and a second timing signal, such that the first timing signal is provided at a time that is different than the second timing signal

In a further embodiment, a method of performing operations is provided. The method can be performed using a compute-in-memory circuit including (i) an array of memory cells including a one or more subgroups, each subgroup of the one or more subgroups storing M stored data elements, M being an integer greater than zero, (ii) multiplier circuits connected to the array of memory cells and to one or more input lines, and (iii) accumulation circuitry including an accumulator input of M data elements connected to a multiplier output. Further, the method can include obtaining M input data elements from the one or more input lines, multiplying, by the multiplier circuits, the M input data elements by the M stored data elements in a selected subgroup of the one or more subgroups to provide a multiplier output having M data elements, wherein the multiplier circuits are enabled by timing control signals to supply a multiplication result to the multiplier output from subgroups in the one or more subgroups in sequence, and generating, by the accumulation circuitry, a sum of the M data elements of the multiplier output.

In another embodiment, a compute-in-memory circuit is provided. The compute-in-memory circuit can include a first subgroup of circuits connected to a first word line and configured to store a first set of weights, a second subgroup of circuits connected to a second word line and configured to store a second set of weights, multiplier circuits configured to (i) multiply, in dependence on a first timing signal, the first set of weights by inputs, (ii) provide first outputs, (iii) multiply, in dependence on a second timing signal, the second set of weights by inputs and (iv) provide second outputs, wherein multiplying of the second set of weights is enabled at a time that is different from a time at which multiplying of the first set of weights is enabled, and accumulation circuitry shared by the first subgroup and the second subgroup and configured to receive and accumulate (i) the first outputs in dependence on the multiplying of the first set of weights being enabled by the first timing signal and (ii) the second outputs in dependence on the multiplying of the second set of weights being enabled by the second timing signal.

In an embodiment, the common lines further can include a bit line bar line (BLB).

In a further embodiment, the common lines can further include a reference voltage line (VREF).

In another embodiment, the array of memory cells can include latches.

Other aspects and advantages of the present invention can be seen on review of the drawings, the detailed description and the claims, which follow.

## BRIEF DESCRIPTION OF THE DRAWINGS

Fig. 1 illustrates a conventional static random access memory (SRAM)-based dCIM system including multiple subgroups of multiplication operators, where each subgroup has a respective and corresponding adder tree (accumulator).

Fig. 2 illustrates an example subgroup of the conventional SRAM-based dCIM system of Fig. 1.

Fig. 3 illustrates a dCIM system including tri-state NOR gates that allow sharing of an adder tree between various subgroups performing MAC operations.

Fig. 4 illustrates a zoomed-in view of portions of three different subgroups of the dCIM system of Fig. 3.

Fig. 5 illustrates the dCIM system of Fig. 3, wherein content (data) is written to subgroup_0 and one or more other subgroups are processing inputs and calculating outputs.

Fig. 6 illustrates a pipelined adder tree used in an embodiment of the dCIM system of Fig. 3.

Fig. 7 illustrates an dCIM system in which two tri-state NOR gates of two different subgroups share an output line and a word line.

Fig. 8 illustrates an adder tree of the dCIM system of Fig. 7.

Fig. 9 illustrates a dCIM system in which four NOR gates of four different subgroups share an output line and a word line.

Fig. 10 illustrates an operational time sequence of subgroup 0 903 through subgroup_7 910 of Fig. 9.

Fig. 11 illustrates a dCIM system in which contents are written using a bit line and a reference voltage (Vref).

Fig. 12 illustrates a dCIM system in which contents are written using sense amplifiers.

Fig. 13 illustrates a timing chart of performing MAC operations using a dCIM system.

Fig. 14 illustrates a dCIM system that uses pass gates rather than the tri-state NOR gates illustrated in Fig. 3.

Fig. 15 illustrates a simplified block diagram of an integrated circuit device including a memory array arranged for in-memory computation with signed (or unsigned) inputs and weights.

## DETAILED DESCRIPTION

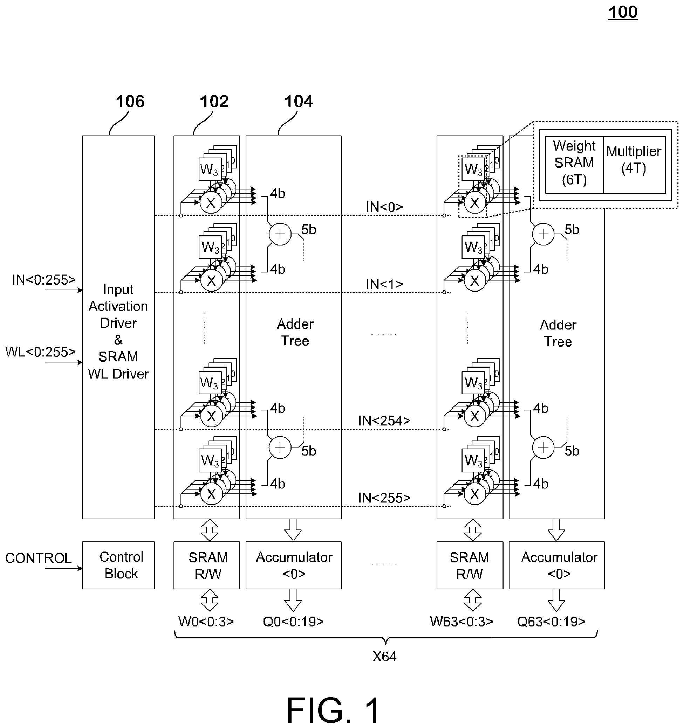

A detailed description of embodiments of the present invention is provided with reference to the Figs. 1-15.

Fig. 1 illustrates a conventional SRAM-based dCIM system including multiple subgroups of multiplication operators, where each subgroup has a respective and corresponding adder tree (accumulator). The dCIM system of Fig. 1 is considered to be SRAM-based because the weights are stored by and read from SRAM.

Specifically, Fig. 1 illustrates conventional SRAM-based dCIM system 100 that includes multiple subgroups of a group, such as subgroup 102, wherein each subgroup utilizes a corresponding adder tree. For example, subgroup 102 receives inputs and word line signals from input activation driver and SRAM WL driver 106, performs mathematical operations, and utilizes adder tree 104 to perform accumulation operations. Each subgroup includes storage circuits for storing weights and circuits for performing mathematical operations, such as multiplying weights by inputs.

In this example, storage devices such as six transistor (6T) SRAM cells, are used to store the weights and multipliers such as four transistor (4T) NOR gates, are used to multiply the weights by inputs (IN<0:255>). Further, as illustrated an Input activation driver and SRAM WL driver receives the inputs on lines IN<0:255> and receives word line signals on word lines WL<0:255>. Each of the inputs IN<0:255> is received by subgroup 102 (as well as the other subgroups) so that they can be multiplied by the stored weights. The word lines WL<0:255> can be used to access the storage devices for reading and writing (e.g., to write the weights to the storage devices and/or read the weights from the storage devices). The outputs of the multiplication operations of the subgroup 102 are provided as inputs 4b to the adder tree 104. The adder tree 104 can combine the various inputs in operation 5b and then provide a single output. In this example, one subgroup having four columns and 256 rows of cells, implements Ini * Wi<0:3> [i=0-255] for a 1024 bit output (one 4 bit output per row) and in combination with the 1024 input bit adder tree, it can complete MAC operations. The multiplication operations can be performed by NOR gates or other types of circuits capable of performing multiplication (or other types of mathematical) operations.

As illustrated, this conventional SRAM-based dCIM system 100 requires a separate adder tree for each subgroup. Here, in this example, there are 64 subgroups and therefore there are 64 adder trees, which occupy a large amount of physical space within the conventional SRAM-based dCIM system 100. Specifically, one of the problems with this conventional SRAM-based dCIM system 100 is that it cannot share adder trees among other subgroups. Therefore, as the adder tree count increases based on the number of subgroups, so does the overall layout size of the SRAM-based dCIM 100 system.

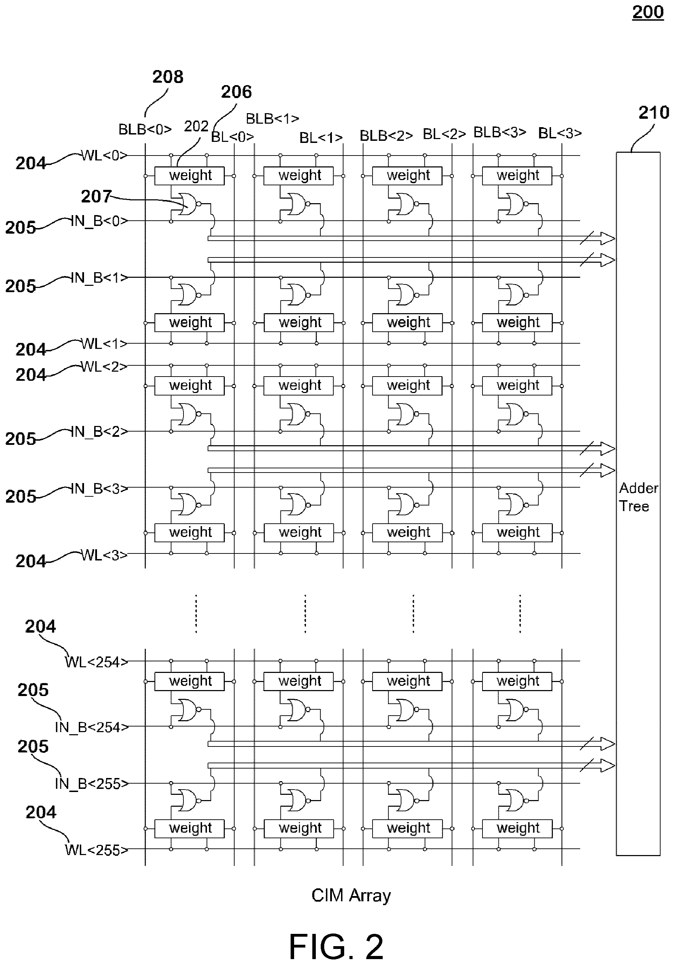

Fig. 2 illustrates an example subgroup of the conventional SRAM-based dCIM system of Fig. 1.

Specifically, Fig. 2 illustrates a subgroup 200 that receives word line inputs 204 (WL<0:255>), inputs 205 (IN_B<0:255>), bit line inputs 206 (BL<0:3>) and bit line bar inputs 208 (BLB<0:3>), wherein the bit line inputs 206 (BL<0:3>) and bit line bar inputs 208 (BLB<0:3>) are for programming storage 202 where the weights are stored. Further, the subgroup 200 includes NOR gates 207 for multiplying the stored weights by the inputs 205. The results of the multiplication are provided to the adder tree 210. As discussed above with reference to Fig. 1, each subgroup 200 communicates with a corresponding adder tree 210. Fig. 2 merely illustrates a single subgroup and one adder tree, but as illustrated in Fig. 1, the SRAM-based dCIM requires at least 64 adder trees.

In order to update the storage 202 of the subgroup to store a new set of weights (e.g., values of weights), all word lines WL<0:255> are sequentially enabled to update all SRAM contents. Updating the storage 202 with the new set of weights is expensive, because of the time it takes to store the new values. Furthermore, because the updating of the storage 202 affects the data received by the adder tree 210, the entire MAC operation of all subgroups must be stopped while the storage 202 is being updated. This further slows down the performance of the SRAM-based dCIM.

The technology disclosed addresses these shortcomings by proving a SRAM-based dCIM that has a reduced layout area with improved performance.

Specifically, in comparison to the systems of Figs. 1 and 2, the technology disclosed uses multipliers having tri-state outputs, such as by replacing the general NOR gates with tri-state NOR gates, wherein the tri-state NOR gates of each subgroups tri-state NOR gate can be controlled by one individual timing signal (e.g., a clock signal, etc.). Alternatively, the tri-state NOR gate can be replaced by any type of logic gate that is able to perform a product operation of an input and stored data (a latched data bit) and/or that can be controlled/enabled according to a timing signal. A tri-state output (of a tri-state NOR gate) has a high impedance state when not activated. This enables many tri-state NOR gate multipliers to connect to each input of the accumulator, in which only activated tri-state NOR gate multipliers selected by the individual timing signals drive the input. This structure enables the sharing of one adder tree with multiple subgroups, resulting in a reduced layout area.

Further, the technology disclosed can arrange each of the subgroups along a WL direction that is perpendicular to the direction of BLs and BLBs, which enables faster downloading of contents into each subgroup by enabling one WL, because an entire subgroup can be active for downloading using a single WL. The physical orientation of the WL direction and the direction of the BLs and BLBs can vary, such that the WL direction and the direction of the BLs and the BLBs can also have non-perpendicular orientations. The result is improved performance, when compared to the system of Fig. 1, because the entire MAC operation does not have to stop when new weights are downloaded. Further, the structure of the technology disclosed allows the output of one subgroup to be processed in one adder tree operation. The technology disclosed implements an architecture, such that other subgroups can keep processing (e.g., performing multiplication operations) when one subgroup is downloading contents (e.g., weights), which further improves performance. The technology disclosed can further be implemented with a structure that allows a single WL to be used to activate/enable multiple subgroups of a group, such that a group can include (be divided into) two, four, eight or even more subgroups using multiple timing signals. The timing signals can be based on any clock cycle or various clock signals and they do not need to be based on just one clock cycle. This structure will enable 1/2, 1/4, 1/8 or fewer multiplication operations per clock cycle, which allows the number of adder tree inputs to be reduced, which further leads to a reduction in the layout size of the adder tree.

Furthermore, an adder tree can require, for example, seven accumulation (addition) layers to go from, for example, 128 inputs to a single output can be 7 (e.g., one layer receives 128 inputs, the next layer receives 64 inputs, the next layer receives 32 inputs, the next layer receives 16 inputs, the next layer receives 8 inputs, the next layer receives 4 inputs, and the next layer receives 2 inputs to then provide the final single). The time that it takes for this number of accumulation layers to fully complete can be longer than it takes for the NOR gates to complete the multiplication operations. As such, the adder tree can be a bottleneck for the MAC operations. Therefore, the technology disclosed can implement a pipelined adder tree that is separated into several stages with buffers or latches between the stages. This allows the adder tree to store the temporary output data from prior stage of the adder tree and act as a pipeline of continuously received inputs. As a result, each stage can run in one clock cycle that coincides with a clock cycle that it takes to complete multiplication operations for a subgroup. This prevents a delay that can be caused by waiting for the adder tree to complete the accumulation operations for all layers before receiving new inputs. As a result, the overall clock cycle of an entire MAC operation can be reduced. In other words, as the adder tree is divided into several stages with buffer (latches) inserted between each stage, the operation of one stage will not impact the operation of another stage, such that the adder tree can operate in a pipeline flow of receiving a new input at every clock cycle. As mentioned above, the technology disclosed herein can also be implemented in near memory computing systems.

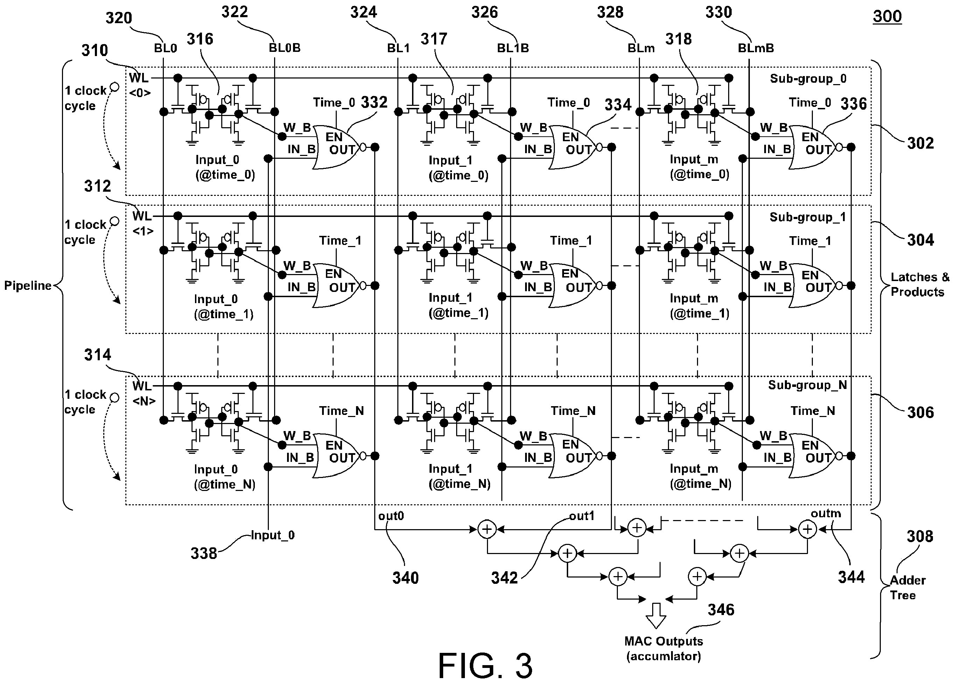

The structures and operations, which enable these above-described features, are described below with reference to Figs. 3-15.

Fig. 3 illustrates a dCIM system including tri-state NOR gates that allow sharing of an adder tree between various subgroups performing MAC operations.

Specifically, Fig. 3 illustrates a dCIM system 300 that includes multiple (N number of) subgroups of circuits including subgroup 0 302, subgroup_1 304 and subgroup N 306 (N being an integer greater than zero). An adder tree 308 (e.g., accumulation circuitry) is connected to the outputs of all of the subgroups (e.g., subgroup 0 302, subgroup_1 304, ....., subgroup N 306), such that all of the subgroups share the adder tree 308. Further, subgroup_0 302 is connected to word line WL<0> 310, subgroup_1 304 is connected to word line WL<1> 312 and subgroup N 306 is connected to word line WL<N> 314. Each of subgroup_0 302, subgroup _1 304 and subgroup N 306 (hereinafter referred to as subgroups 302, 304 and 306) is individually activated or enabled for storing contents by their respective word lines 310, 312 and 314. A group can be referred to as a collection of subgroups, such as subgroups 302, 304 and 306, that share the same adder tree 308.

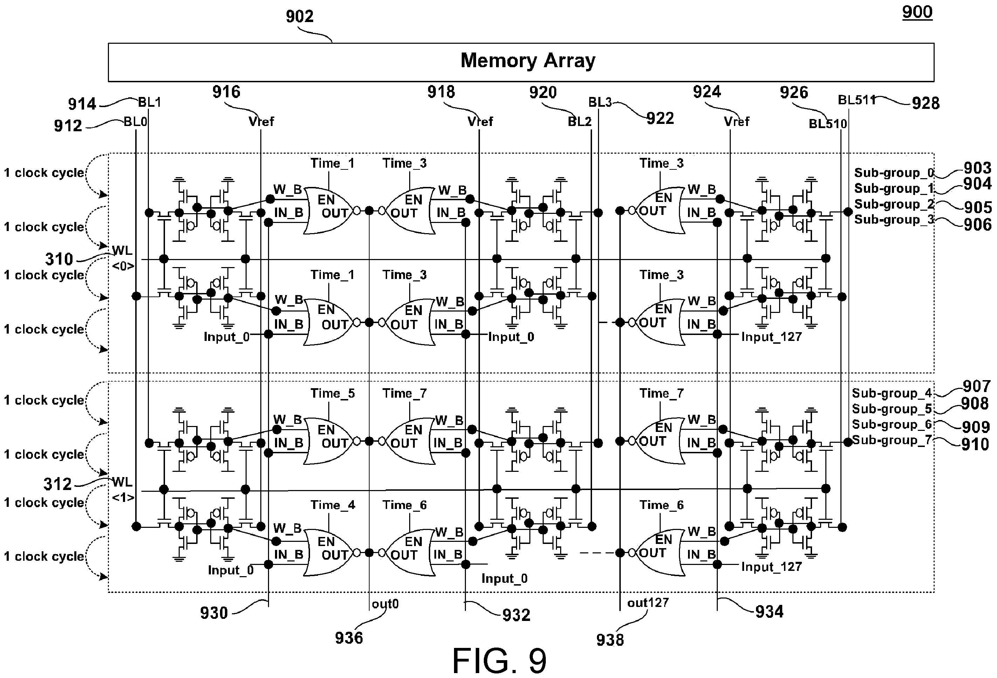

As illustrated, each of the subgroups 302, 304 and 306 can include storage circuits and/or multiplication (multiplier) circuits. Further, the subgroups 302, 304 and 306 can be referred to an array of memory cells, such that each subgroup includes memory cells that store data elements, wherein the multiplier circuits are connected to the array of memory cells and to one or more input lines that provides M (or some other number) input data elements on one or more input lines, contents and/or multipliers. For example, subgroup 302 includes storage circuits 316, 317 and 318 (e.g., an array of memory cells). Each subgroup can include M (or some other number) storage circuits that store M stored data elements. The storage circuits 316, 317 and 318 can any type of memory, including, but not limited to, latches, sense amplifier (SA) latches, SRAM, DRAM, other types of volatile memory and even NVM (a SA latch can be used to sense the data of a memory array, e.g., memory array 902 of Fig. 9, and store sensed data). This also applies to any of the storage circuits (arrays of memory cells) described herein with respect to Fig. 3-15. For example, the storage circuits 316, 317 and 318 can be configured with six transistors (6T). For example, a 6T SRAM cell connected to true and complement bit lines by activating the word lines, with an additional output connected to the multiplier circuit so that the data stored in the cell can be multiplied by the input bit without activating the word lines. Other types of storage circuits can be implemented as well. Subgroups 304 and 306 include similar storage circuits. Content can be written to storage circuits 316 (e.g., contents can be downloaded thereto for programming of the dCIM system 300) using bit line BL0 320 and bit line bar line BL0B 322 (e.g., common lines) in combination with the activation of word line WL<0> 310, which is connected to each of the storage circuits of subgroup 302. As illustrated, BL0 320 and BL0B 322 can be perpendicular to word line WL<0> 310. Other orientations of the word lines, bit lines and bit line bar lines can be implemented. Additionally, BL0 320 and BL0B 322 are connected to corresponding storage circuits of subgroups 304 and 306, such that BL0 320 and BL0B 322 are shared by the storage circuits of subgroups 302, 304 and 306. As illustrated, there is essentially a column of storage circuits of subgroups 302, 304 and 306 that are connected by BL0 320 and BL0B 322.

BL1 324 and BL1B 326 are connected to storage circuits 317 for writing content to the storage circuits 317, as well as writing content to the corresponding storage circuits of subgroups 304 and 306, such that BL1 324 and BL1B 326 (e.g., common lines) are shared by the storage circuits of subgroups 302, 304 and 306. BLm 328 and BLmB 330 (e.g., common lines) are connected to storage circuits 318 for writing content to the storage circuits 318, as well as writing content to the corresponding storage circuits of subgroups 304 and 306, such that BLm 328 and BLmB 330 are shared by the storage circuits of subgroups 302, 304 and 306. Activation of the various word lines 310, 312 and 314 controls which subgroups have contents written thereto.

Semantically, the multiplier circuits can be referred to as being part of a subgroup or they can be referred to as being for a subgroup, but not actually part of the subgroup. For example, subgroup 302 can include multiplier circuitry, such as tri-state NOR gates 332, 334 and 336 (also referred to as tri-state multipliers). As illustrated in Fig. 3, as well as in the subsequent figures, the storage circuits 316, 317 and 318 can have read and write ports connected to bit line and bit line bar and can have a separate read port connected to a tri-state NOR gate. Each subgroup includes m number of tri-state NOR gates. Tri-state NOR gate 332 is connected to storage circuits 316, such that tri-state NOR gate 332 can obtain the weight (content, input/stored data element) stored by storage circuits 316 and multiply the obtained weight by an input, such as input_0 received on input_0 line 338. Tri-state NOR gate 332 only outputs the multiplication when it is enabled by a timing signal (e.g., a first timing signal Time_0). Timing control signals can include several different timing signals and/or control transmission of different timing signals, such as the first timing signal Time_0, a second timing signal Time_1 and an Nth timing signal Time_N, or any other timing signals described herein. Further, the timing control signals can be connected to the multiplier circuits to enable them to supply a multiplication result to a multiplier output from the subgroups, of a one or more subgroups, in sequence. A timing control signal can be said to select a particular subgroup (e.g., the first timing signal Time_0 can be said to select subgroup 302, the second timing signal Time_1 can be said to select subgroup 304 and the Nth timing signal Time N can be said to select subgroup 306).

Input 0 can be received (on an input line from an input driver) at or about the same time as the timing signal (e.g., the first timing signal Time_0). As illustrated, the input_0 can be received at IN_B of the tri-state NOR gate 332 and the weight can be received at W_B of the tri-state NOR gate 332. The output of the multiplication performed by the tri-state NOR gate 332 is provided on an output line out0 340 (e.g., a first output line) that is received by the adder tree 308. Output line out0 340 is shared by the tri-state NOR gates of each of the subgroups 302, 304 and 306. As illustrated, the column of tri-state NOR gates, including tri-state NOR gate 332, extending through subgroups 302, 304 and 306 share the same output line out0 340. However, at time_0, the time at which the timing signal enables tri-state NOR gate 332, the only output provided to output line out0 340 is provided from tri-state NOR gate 332 because the other tri-state NOR gates from the other subgroups 304 and 306 are not enabled.

Similarly, tri-state NOR gate 334 is connected to storage circuits 317, such that tri-state NOR gate 334 can obtain the weight (content) stored by storage circuits 317 and multiply the obtained weight by an input, such as input 1 received on an input line. Tri-state NOR gate 334 only outputs (or performs) the multiplication when it is enabled by the timing signal (e.g., the first timing signal Time_0). Input 1 can be received at or about the same time as the timing signal (e.g., the first timing signal Time_0). As illustrated, the input 1 can be received at IN_B of the tri-state NOR gate 334 and the weight can be received at W_B of the tri-state NOR gate 334. The output of the multiplication performed by the tri-state NOR gate 334 is provided on an output line out1 342 (e.g., a second output line) that is received by the adder tree 308. Output line out1 342 is shared by the tri-state NOR gates of each of the subgroups 302, 304 and 306, just as described above with respect to output line out0 340.

Similarly, tri-state NOR gate 336 is connected to storage circuits 318, such that tri-state NOR gate 336 can obtain the weight (content) stored by storage circuits 318 and multiply the obtained weight by an input, such as input m received on an input line. Tri-state NOR gate 336 only outputs (or performs) the multiplication when it is enabled by the timing signal (e.g., the first timing signal Time_0). Input m can be received at or about the same time as the timing signal (e.g., the first timing signal Time_0). As illustrated, the input m can be received at IN_B of the tri-state NOR gate 336 and the weight can be received at W_B of the tri-state NOR gate 336. The output of the multiplication performed by the tri-state NOR gate 336 is provided on an output line outm 344 that is received by the adder tree 308. Output line outm 344 is shared by the tri-state NOR gates of each of the subgroups 302, 304 and 306, just as described above with respect to output line out0 340. There can be M (or some other number) of output lines for each subgroup.

The tri-state NOR gates of subgroup 304 can be enabled by a timing signal (e.g., a second timing signal Time_1) and can receive input_0, input 1 through input m at or around the same time. In the same manner as subgroup 302, the circuitry of subgroup 304 multiplies the weights by the inputs to provide outputs to the adder tree 308. Further, the tri-state NOR gates of subgroup 306 can be enabled by a timing signal (e.g., an Nth timing signal Time_N) and can receive input_0, input_1 through input_m at or around the same time. In the same manner as subgroups 302, 304 the circuitry of subgroup 306 multiplies the weights by the inputs to provide outputs to the adder tree 308. As illustrated, it can take 1 clock cycle for subgroup 302 to provide outputs out0 340 through outm 344, then at the next clock cycle subgroup 304 provides outputs out0 340 through outm 344 and then at a later Nth clock cycle subgroup 306 provides outputs out0 340 through outm 344. The multiplication performed by each of the subgroups 302, 304 and 306 is controlled by a different timing signal. When referring to timing signals herein, a timing signal can include multiple separate timing signals. Other timing signal schemes can be used to enable and control the tri-state NOR gates as described herein.

The outputs of each subgroups 302, 304 and 306 are accumulated and provided as MAC outputs 346, such that the output of subgroup 302 is provided as a MAC output 346, then the output of subgroup 304 is provided as a MAC output 346 and eventually the output of subgroup 306 is provided as a MAC output 346.

Subgroup 302 can be referred to as a first subgroup of circuits that is connected to a first word line (e.g., word line WL<0> 310) and that is configured to (i) store a first set of weights, (ii) multiply, in dependence on a first timing signal (e.g., at Time_0), the first set of weights by inputs and (iii) provide first outputs (out_0 340 through outm 344). Subgroup 304 can be referred to as a second subgroup of circuits that is connected to a second word line (e.g., word line WL<1> 312) and that is configured to (i) store a second set of weights, (ii) multiply, in dependence on a second timing signal (e.g., at Time_1), the second set of weights by inputs and (iii) provide second outputs (out0 340 through outm 344), wherein multiplying of the second set of weights is enabled at a time that is different from a time at which multiplying of the first set of weights is enabled. Adder tree 308 can be referred to as accumulation circuitry that shared by the first subgroup (e.g., subgroup 302) and the second subgroup (e.g., subgroup 304) and configured to receive and accumulate (i) the first outputs in dependence on the multiplying of the first set of weights being enabled by the first timing signal (e.g., Time_0) and (ii) the second outputs in dependence on the multiplying of the second set of weights being enabled by the second timing signal (e.g., Time_1).

Further, storage circuits 316, 317 and 318 of subgroup 302 can be referred to as first storage circuits and tri-state NOR gates 332, 334 and 336 can be referred to as first multiplication circuits, wherein the first storage circuits are connected to the first word line and are configured (can be written to in order) to store the first set of weights and wherein the first multiplication circuits are enabled by the first timing signal to multiply the first set of weights by inputs to provide the first outputs. In addition, the storage circuits of subgroup 304 can be referred to as second storage circuits and the tri-state NOR gates of subgroup 304 can be referred to as second multiplication circuits, wherein the second storage circuits are connected to the second word line and are configured (can be written to in order) to store the second set of weights and wherein the second multiplication circuits are enabled by the second timing signal to multiply the second set of weights by inputs to provide the second outputs, the second multiplication circuits being enabled at a time that is different from a time at which the first multiplication circuits are enabled, such that the accumulation circuitry (e.g., the adder tree 308) receives and accumulates (i) the first outputs in dependence on the first multiplication circuits being enabled by the first timing signal and (ii) the second outputs in dependence on the second multiplication circuits being enabled by the second timing signal. The accumulation circuitry 308 can include an accumulator input of N data elements connected to the multiplier output (e.g., the output of the multiplier circuits, such as the tri-state NOR gates). The accumulation circuitry 308 can also generate a sum of the N data element of the multiplier output.

The dCIM system 300 of Fig. 3 can receive the data elements for storage in the array of memory cells (e.g., the storage circuits) from a non-volatile memory (NVM) array, such as NOR flash memory, NAND flash memory, etc. This type of dCIM system 300 can be referred to as an NVM-based dCIM system. Further, the dCIM system 300 of Fig. 3 can receive the data elements for storage in the array of memory cells from a volatile memory array, such as dynamic random access memory (DRAM), SRAM etc. These types of dCIM systems can be referred to as SRAM-based dCIM systems, DRAM-based dCIM systems and/or volatile memory-based dCIM systems, etc. Any of the dCIM systems described herein with respect to Figs. 3-15 can be any of the NVN-based dCIM systems and volatile memory-based dCIM systems, as described above.

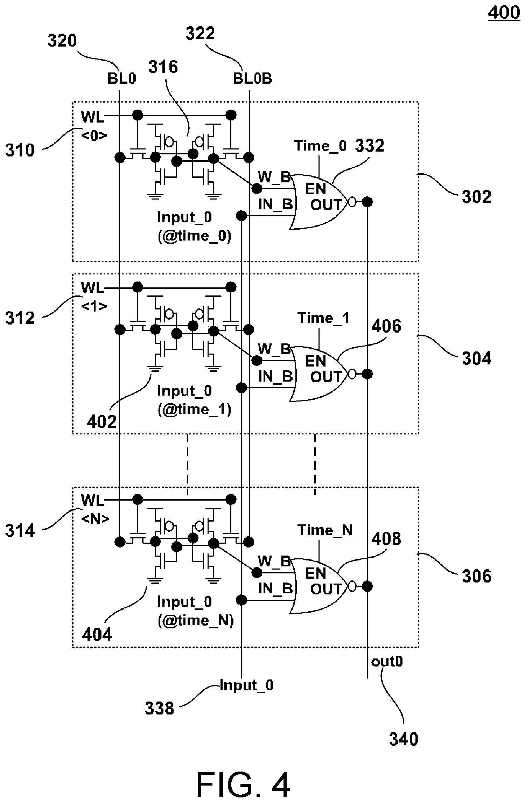

Fig. 4 illustrates a zoomed-in view of portions of three different subgroups of the dCIM system of Fig. 3.

Specifically, Fig. 4 illustrates a zoomed-in view 400 of portions of subgroups 302, 304 and 306. As illustrated word line WL<0> 310 is connected to the storage circuits 316 of subgroup 302, word line WL<1> 312 is connected to the storage circuits 402 of subgroup 304 and word line WL<N> 314 is connected to the storage circuits 404 of subgroup 306. Tri-state NOR gate 332 of subgroup 302 receives and is enabled by a first timing signal (Time 0), receives a stored weight from storage circuits 316, receives input_0 on input line input_0 338 on or around the time that the first timing signal (Time 0) is received, multiplies the received weight by the input 0 on input line input 0 338 to provide an output on output line out0 340. As previously mentioned, the storage circuity 316 and the tri-state NOR gate 332 are just examples and different types of storge circuits for storage and gates, etc. for performing mathematical operations and can be implemented using different technologies.

Similarly, tri-state NOR gate 406 of subgroup 304 receives and is enabled by a second timing signal (Time_1), receives a stored weight from storage circuits 402, receives input 0 on input line input 0 338 on or around the time that the second timing signal (Time_1) is received, multiplies the received weight by the input_0 to provide an output on output line out0 340. Further, tri-state NOR gate 408 of subgroup 306 receives and is enabled by an Nth timing signal (Time N), receives a stored weight from storage circuits 404, receives input_0 on input line input_0 338 on or around the time that the Nth timing signal (Time N) is received, multiplies the received weight by the input 0 to provide an output on output line out0 340.

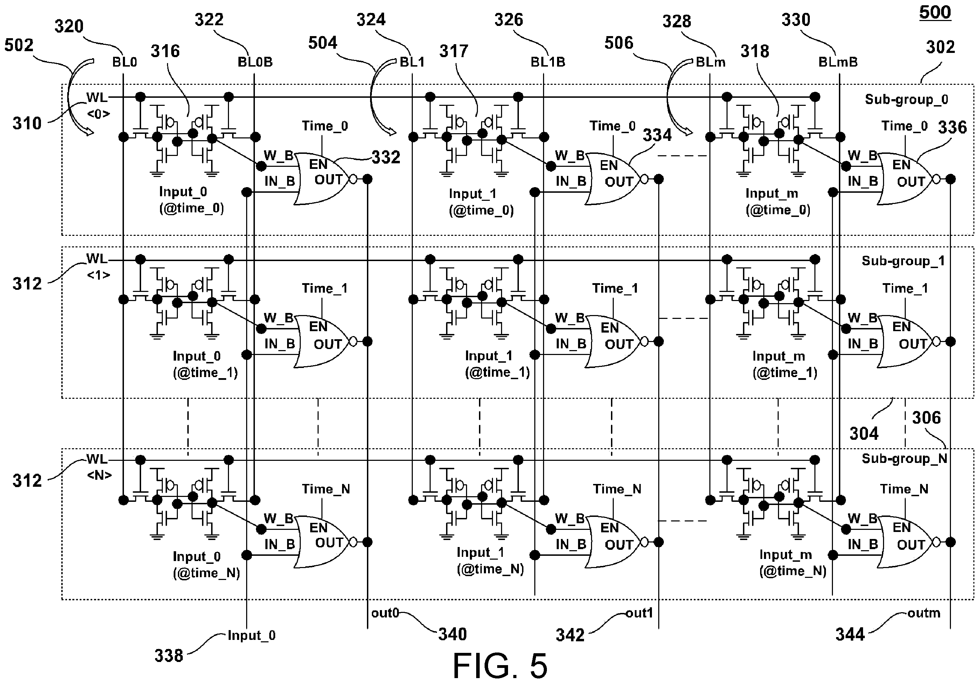

Fig. 5 illustrates the dCIM system of Fig. 3, wherein content (data, such as N stored data elements) is written to subgroup_0 and one or more other subgroups are processing inputs and calculating outputs. Throughout this document, content that is written to storage circuitry can be referred as weights, stored data elements, etc. The content can be written to various subgroups in an operation to download sets of weights.

Specifically, Fig. 5 illustrates a dCIM system 500 that is the same as the dCIM system 300 as described with reference to Fig. 3 and redundant descriptions are omitted herewith. In addition to what is described with reference to Fig. 3, Fig. 5 illustrates that content is written to storage circuits 316 of subgroup 302 in operation 502, content is written to storage circuits 317 of subgroup 302 in operation 504, and content is written to storage circuity 318 of subgroup 302 in operation 506 contents. The content (data) that is written can include weights, such as a first set of weights. In this example, the storage circuits of subgroups 304 and 306 can already have weights stored therein (e.g., the storage circuits of subgroup 304 can have a second set of weights stored therein and the storage circuits of subgroup 306 can have an Nth set of weights stored therein). While storage circuits 316, 317 and 318 of subgroup 302 are having content written thereto, the multiplication circuits (e.g., the tri-state NOR gates) of subgroup 304 or of subgroup 306 can perform the multiplication component of the MAC operations to provide outputs to an adder tree (e.g., an accumulator).

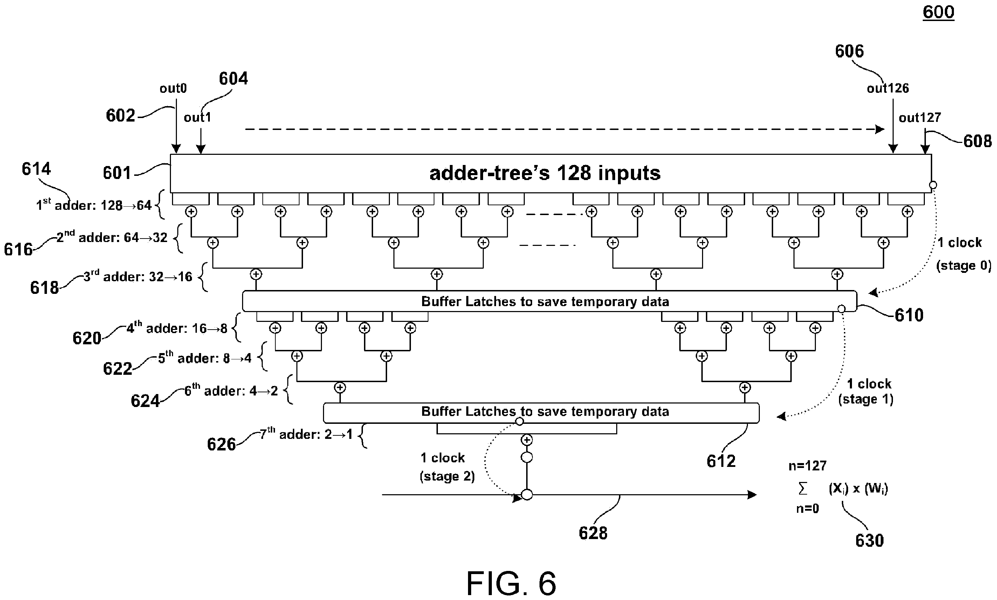

Fig. 6 illustrates a pipelined adder tree used in an embodiment of the dCIM system of Fig. 3.

Specifically, Fig. 6 illustrates an adder tree 600 (e.g., accumulation circuitry) that receives 128 outputs on the output lines connected to the tri-state NOR gates of the dCIM system of Fig. 3. Output out0 602, output out1 604 through output out126 606 and output out127 608 are received as inputs 601 of the adder tree 600. The adder tree 600 has seven layers, including a first adder layer 614 that adds the 128 inputs to provide 64 results, a second adder layer 616 that adds the 64 results to provide 32 results, a third adder layer 618 that adds the 32 results to provide 16 results, a fourth adder layer 620 that adds the 16 results to provide 8 results, a fifth adder layer 622 that adds the 8 results to provide 4 results, a sixth adder layer 624 that adds the 4 results to provide 2 results and a seventh adder layer 626 that adds the 2 results to provide a single output to path 628. The single output provided on path 628 is the mathematical equivalent of equation 630, which is the result of the entire MAC operation (of a particular subgroup, such as subgroup 302 of Fig. 3.

As illustrated, the adder tree 600 includes buffer latches 610 and 612 for pipeline stages, that temporarily store intermediate and final results of the accumulation operations. For example, buffer latches 610 store the 16 results provided by the third adder layer 618 and buffer latches 612 store the 2 results provided by the sixth adder layer 624. Furthermore, as illustrated, it takes one clock cycle to receive the 128 inputs and to store the 16 results in buffer latches 610, it also takes one clock cycle to take the 16 results stored in buffer latches 610, to perform accumulation operations, and to store the 2 results in the buffer latches 612 and it takes 1 clock cycle to take the 2 results stored in buffer latches 612, to perform accumulation operations, and to prove the single output to path 628. The adder tree 600 is structured, such that, for example, at a certain clock cycle (time), 128 outputs can be received from subgroup 302 of Fig. 3 and stored in buffer latches 610 while subgroup 304 is performing multiplication operations. At a subsequent clock cycle (subsequent time), 128 outputs can be received from subgroup 304 and stored in buffer latches 610 while the previous contents of buffer latches 610 (based on the operations of subgroup 302) are added and stored in buffer latches 612. At a further subsequent clock cycle (a further subsequent time), 128 output can be received from subgroup 306 and stored in buffer latches 610, while the previous contents of buffer latches 610 (based on the operations of subgroup 304) are added and stored in buffer latches 612, and while the previous contents of buffer latches 612 (based on the operations of subgroup 302) are added and provided as the single output on path 628. The adder tree 600 can be said to have three stages, the first stage (stage 0) includes receiving inputs and storing in the buffer latches 610, the second stage (stage 1) includes processing data from buffer latches 610 and storing in buffer latches 612 and the third stage (stage 2) includes processing data from buffer latches 612 and providing the single output to path 628.

This pipeline operation continues while the subgroups of the dCIM system continue to have contents written thereto and continue perform the multiplication operations. This pipeline operation allows the MAC operations to continue without interruption, because it eliminates the need for the dCIM system to wait for the adder tree 600 to complete the accumulation and provide a result. Accordingly, the adder tree 600 is essentially able to have a faster clock and higher throughput. For example, as illustrated and describe above, the adder tree 600 actually takes three clock cycles to take the 128 inputs and provide a single output. Therefore, without the buffer latches 610 and 612, the multiplication operations, which only take one clock cycle, would have to wait three clock cycles for the adder tree to complete the accumulation operations. As a result, the dCIM system with this adder tree structure operates significantly faster.

Alternatively, the adder tree 600 (or any other adder tree described herein) can operate without the buffer latches. Further, the buffer latches can be any type of circuits or component that can store data. Moreover, the adder tree 600 (or any other adder tree described herein) can be a counter that performs a population count (to count the "1" number).

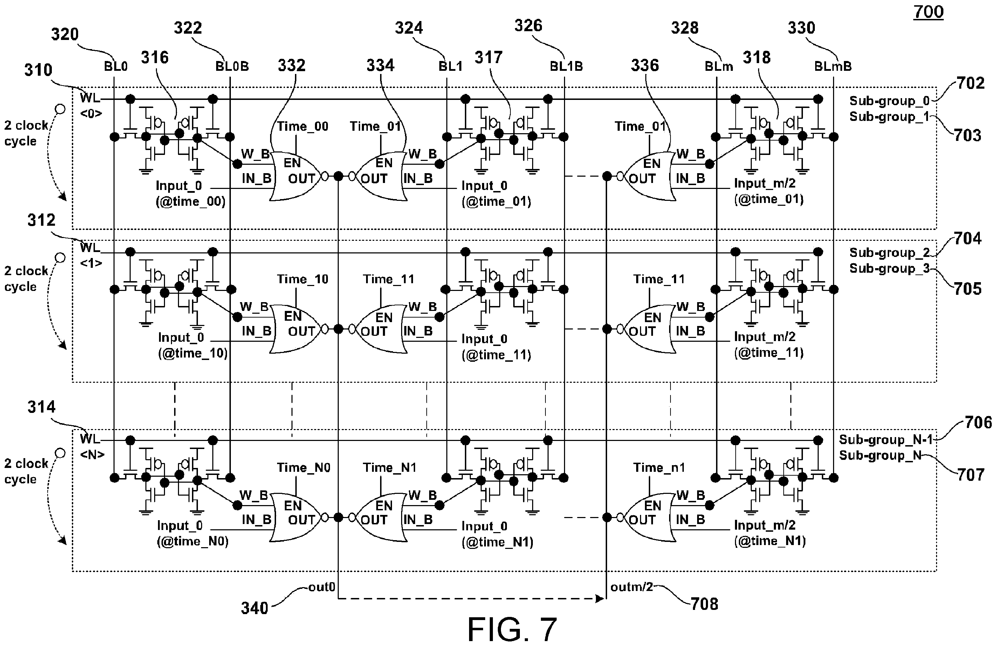

Fig. 7 illustrates a dCIM system in which two tri-state NOR gates of two different subgroups share an output line and a word line.

Specifically, Fig. 7 illustrates a similar dCIM system 700 as described with reference to Fig. 3 and redundant descriptions are omitted herewith. The dCIM system 700 of Fig. 7 is different from the dCIM system 300 of Fig. 3, in that subgroup_0 702 and subgroup_1 703 are connected to a same word line WL<0> 310, subgroup_2 704 and subgroup_3 705 are connected to a same word line WL<1> 312 and subgroup N-1 706 and subgroup N 707 are connected to a same word line WL<N> 314. The dCIM system 700 of Fig. 7 includes the same word lines 310, 312 and 314, the same storage circuits 316, 317 and 318, the same bit lines and bit line bar lines 320, 322, 324, 326, 328 and 330 and the same tri-state NOR gates 332, 334 and 336 as discussed above with reference to Fig. 3.

The dCIM system 700 of Fig. 7 is also different because two tri-state NOR gates of two different subgroups 702 and 703 share an output line out0 340 and a word line 310. For example, tri-state NOR gate 332 of subgroup 702 and the tri-state NOR gate 334 of subgroup 703 both provide outputs to output line out0 340. Similarly, two of the tri-state NOR gates of two different subgroups 704 and 705 provide outputs to the same output line out0 340 and two of the tri-state NOR gates of two different subgroups 706 and 707 provide outputs to the same output line out 340.

In this example, if there are 128 tri-state NOR gates within subgroups 702 and 703, 64 tri-state NOR gates are members of subgroup 702 and 64 tri-state NOR gates are members of subgroup 703. Further, in this example, tri-state NOR gate 332 is a member of subgroup 702 and tri-state NOR gates 334 and 336 are members of subgroup 703. Additionally, 64 tri-state NOR gates are members of subgroup 704 and 64 tri-state NOR gates are members of subgroup 705. Similarly, 64 tri-state NOR gates are members of subgroup 706 and 64 tri-state NOR gates are members of subgroup 707.

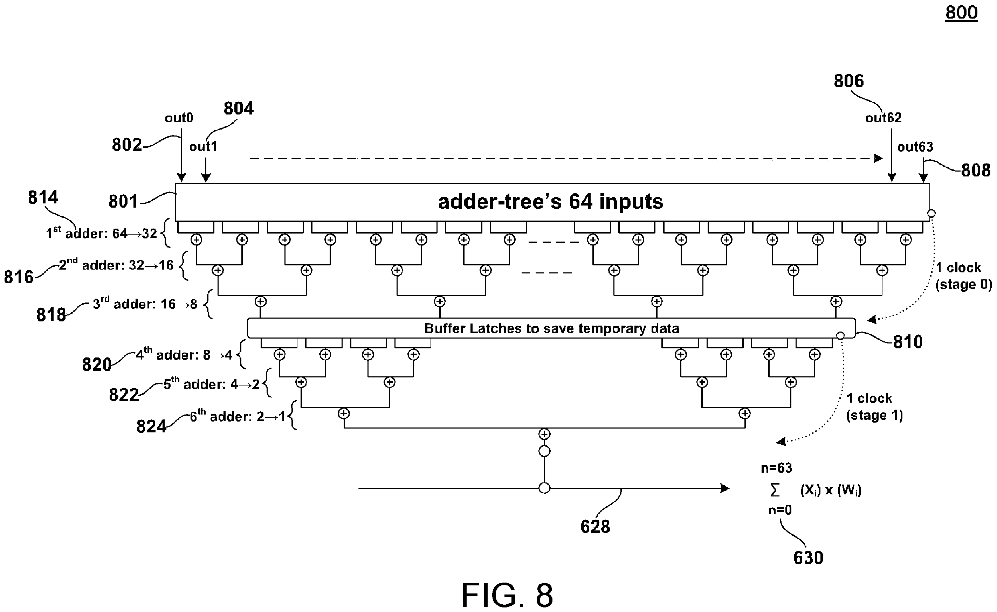

As illustrated, at time_00 (e.g., a first clock cycle), tri-state NOR gates that are members of subgroup 702 provide 64 outputs on output lines out0 340 through outm/2 708. In this example, m (or L) = 128, meaning that there are 128 tri-state NOR gates for subgroups 702 and 703 combined and that there are 64 (128/2) outputs. Because of this subgroup architecture of the dCIM system 700, there are 64 outputs per clock cycle, as opposed to 128 outputs per clock cycle, as discussed above with reference to the dCIM system 300 of Fig. 3. At time_01 (e.g., a second clock cycle), the tri-state NOR gates of subgroup 703 are enabled to multiply and provide the 64 outputs. As a result, subgroups 702 and 703 are utilized for 2 clock cycles, which can provide additional clock cycles for writing contents to other groups while subgroups 702 and 703 are performing multiplication and also allows for the use of a smaller adder tree (accumulator), as discussed below with reference to Fig. 8. Contents can be written to the multiple subgroups that are connected to the same word line concurrently.

Turning back to Fig. 7, at time_10 (e.g., a third clock cycle), tri-state NOR gates that are members of subgroup 704 provide 64 outputs on output lines out0 340 through outm/2 708. At time_11 (e.g., a fourth clock cycle), the tri-state NOR gates of subgroup 705 are enabled to multiply and provide the 64 outputs. At time_N0 (e.g., an (N-1)th clock cycle), tri-state NOR gates that are members of subgroup 706 provide 64 outputs on output lines out0 340 through outm/2 708. At time_N1 (e.g., a Nth clock cycle), the tri-state NOR gates of subgroup 707 are enabled to multiply and provide the 64 outputs. This architecture illustrated in Fig. 7 can be modified to include 8 or more subgroups per group. For example, the number of "neighboring" NOR gates of a subgroups 702 and 703 sharing the same output line can be 2, 4, 8 or any $2^N$ number, N being an integer.

Fig. 8 illustrates an adder tree of the dCIM system of Fig. 7.

As described above, the dCIM system 700 of Fig. 7 provides, for example, 64 outputs per clock cycle, as opposed to the 128 outputs per clock cycle of the dCIM system 300 of Fig. 3. The adder tree 800 of Fig. 8 has 64 inputs to receive the 64 outputs of the dCIM system 700 of Fig. 7.

Specifically, the adder tree 800 receives output out0 802, output out1 804 through output out62 806 and output out63 808. These output are received as 64 inputs 801 of the adder tree 800. This adder tree 800 has one less layer than the adder tree 600 of Fig. 6. For example, adder tree 800 incudes (i) first adder tree layer 814 that receives the 64 inputs and provides 32 results, (ii) second adder tree layer 816 that receives the 32 results and provides 16 results, (iii) third adder tree layer 818 that receives the 16 results and provides 8 results, (iv) buffer latches 810 that receive and temporarily store the 8 results, (v) fourth adder tree layer 820 that receives the temporarily stored 8 results and provides 4 results, (vi) fifth adder tree layer 822 that receives the 4 results and provides 2 results and (vii) sixth adder tree layer 824 that receives the 2 results and provides a single result. Similar to the adder tree 600 of Fig. 6, the adder tree 800 provides the single result on path 628, wherein the single result is the mathematical equivalent of equation 630, which is the result of the entire MAC operation of a particular subgroup.

As illustrated, the adder tree 800 completes the accumulation operations in two clock cycles, where it takes one clock cycle (stage 0) to receive inputs and store results in the buffer latches 810 and it takes one clock cycle (stage 1) to take the stored data from the buffer latches 810 and provide the single output. This is the same pipeline structure discussed above with respect to the adder tree 600, except that there is only one buffer latch, as opposed two and except that it only takes two clock cycles to complete the accumulation operations as opposed to three clock cycles. The number of buffer latches and required clock cycles is reduced because the adder tree 800 only receives 64 inputs, as opposed to the 128 inputs of the adder tree 600. As a result, a gate count (i.e., gates that perform the accumulation) of the adder tree 800 is about half of the gate count of the adder tree 600, such that the size of the adder tree 800 is about half of the size of the adder tree 600. This adder tree 800 with fewer inputs can be implemented as a result of the subgroup structure and the sharing of output lines, as discussed above with reference to Fig. 7.

Fig. 9 illustrates an dCIM system in which four NOR gates of a four different subgroups share an output line and a word line.

The dCIM system 900 of Fig. 9 is similar to the dCIM system 700 of Fig. 7, and redundant descriptions of components that are described with reference to Fig. 7 are omitted herewith.

The dCIM system 900 of Fig. 9 is different from the dCIM system 700 of Fig. 7, in that there are four different subgroups of tri-state transistors that share an output line and a word line. Specifically, Fig. 9 illustrates that four subgroups (i.e., subgroup_0 903, subgroup_1 904, subgroup_2 905 and subgroup_3 906, hereinafter subgroups 903, 904, 905 and 906) are connected to a same word line WL<0> 310 and further illustrates that four subgroups (i.e., subgroup_4 907, subgroup_5 908, subgroup_6 909 and subgroup 7 910, hereinafter subgroups 907, 908, 909 and 910). Additional stet of four subgroups, up through subgroups N-3, N-2, N-1 and N can be connected to their respective word lines. The dCIM system 900 of Fig. 9 includes the same word lines 310 and 312, the same storage circuits and the same tri-state NOR gates as discussed with respect to Figs. 3 and 7.

Subgroup 903 includes storage circuits and tri-state NOR gates associated with time_0, subgroup 904 includes storage circuits and tri-state NOR gates associated with time_1, subgroup 905 includes storage circuits and tri-state NOR gates associated with time_2, subgroup 906 includes storage circuits and tri-state NOR gates associated with time_3, subgroup 907 includes storage circuits and tri-state NOR gates associated with time_4, subgroup 908 includes storage circuits and tri-state NOR gates associated with time_5, subgroup 909 includes storage circuits and tri-state NOR gates associated with time_6, and subgroup 910 includes storage circuits and tri-state NOR gates associated with time _7.

The bit line configuration of Fig. 9 is different from the bit line configuration of Fig. 7. Specifically, bit lines BL0 912 and BL1 914 and Vref916 (e.g., reference voltage line) are implemented to write contents to certain storage circuits of subgroups 903, 904, 907 and 908 (e.g., the storage circuits in the first column on the left). As illustrated, Vref 916 is connected to the storage circuits above and below word line WL<0> 310 and the storage circuits above and below word line WL<1> 312, whereas bit line BL1 914 is connected to the storage circuits above word line WL<0> 310 and above word line WL<1> 312 and bit line BL0 912 is connected to storage circuits below word line WL<0> 312 and below word line WL<1> 312. Further, bit lines BL2 920 and BL3 922 and Vref 918 are implemented to write contents to certain storage circuits of subgroups 905, 906, 909 and 910 (e.g., the storage circuits in the second column that is to the right of the first column). As illustrated, Vref 918 is connected to the storage circuits above and below word line WL<0> 310 and the storage circuits above and below word line WL<1> 312, whereas bit line BL3 922 is connected to the storage circuits above word line WL<0> 310 and above word line WL<1> 312 and bit line BL2 920 is connected to storage circuits below word line WL<0> 312 and below word line WL<1> 312. Bit lines BL510 926 and BL511 928 and Vref 924 are implemented to write contents to certain storage circuits of subgroups 905, 906, 909 and 910 (e.g., the storage circuits in the rightmost column). As illustrated, Vref924 is connected to the storage circuits above and below word line WL<0> 310 and the storage circuits above and below word line WL<1> 312, whereas bit line BL511 928 is connected to the storage circuits above word line WL<0> 310 and above word line WL<1> 312 and bit line BL510 926 is connected to storage circuits below word line WL<0> 312 and below word line WL<1> 312.

The dCIM system 900 of Fig. 9 is also different from the dCIM system 700 because four tri-state NOR gates of the subgroups 903, 904, 905 and 906 and four tri-state NOR gates of the subgroups 907, 908, 909 and 910 share an output line out0 936. For example, tri-state NOR gates associated with times 0, 1, 2 and 3 of subgroups 903, 904, 905 and 905 can all provide outputs to output line out0 904. Similarly, the tri-state NOR gates associated with times 4, 5, 6, and 7 of subgroups 907, 908, 909 and 910 provide outputs to the same output line out0 936. Input lines 930, 932 and 934 provide inputs to the various tri-state NOR gates.

In this example, if there are 512 tri-state NOR gates within subgroups 903, 904, 905 and 906, 128 tri-state NOR gates are members of subgroup 903, 128 tri-state NOR gates are members of subgroup 904, 128 tri-state NOR gates are members of subgroup 905 and 128 tri-state NOR gates are members of subgroup 906. Additionally, 128 tri-state NOR gates are members of subgroup 907, 128 tri-state NOR gates are members of subgroup 908, 128 tri-state NOR gates are members of subgroup 909 and 128 tri-state NOR gates are members of subgroup 910. Other configurations are possible, depending on the number of desired outputs per clock cycle. In this example of Fig. 9, there are 128 outputs. If there were 64 outputs, then the number of tri-state NOR gates per subgroup would be reduced to 64.

As illustrated, at time_0 (e.g., a first clock cycle), tri-state NOR gates that are members of subgroup 903 provide 128 outputs on output lines out0 936 through out127 938. At time_1 (e.g., a second clock cycle), the tri-state NOR gates of subgroup 904 are enabled to multiply and provide the 128 outputs. At time_2 (e.g., a third clock cycle), the tri-state NOR gates of subgroup 905 are enabled to multiply and provide the 128 outputs. At time_3 (e.g., a fourth clock cycle), the tri-state NOR gates of subgroup 906 are enabled to multiply and provide the 128 outputs. As a result, subgroups 903, 904, 905 and 906 are utilized for four clock cycles, which allows for additional clock cycles for writing contents to other subgroups connected to other word lines.

At time_4 (e.g., a fifth clock cycle), tri-state NOR gates that are members of subgroup 907 provide 128 outputs on output lines out0 936 through out127 938. At time_5 (e.g., a sixth clock cycle), tri-state NOR gates that are members of subgroup 908 provide 128 outputs on output lines out0 936 through out127 938. At time_6 (e.g., a seventh clock cycle), tri-state NOR gates that are members of subgroup 909 provide 128 outputs on output lines out0 936 through out127 938. At time_7 (e.g., an eighth clock cycle), tri-state NOR gates that are members of subgroup 910 provide 128 outputs on output lines out0 936 through out127 938.

Fig. 9 further illustrates that contents of a memory array 902 are written to the storage circuits of subgroups 903, 904, 905, 906, 907, 908, 909 and 910. As previously described, the memory array 902 that stores contents (data elements) can be any type of NVM and volatile memory. The contents (data elements) of the memory array 902 can be written to the storage circuits of subgroups 903, 904, 905 and 906 while subgroups 907, 908, 909 and 910 are performing the multiplication operations and contents can be written to the storage circuits of subgroups 907, 908, 909 and 910 while subgroups 903, 904, 905 and 906 are performing the multiplication operations. It is possible to write to any subgroups that do not share a word line with an active subgroup. As illustrated, two storage circuits on a single word line (e.g., WL<0> 310) can share an output line (e.g., out0 936), can be connected to separate bit lines (e.g., BL0 912 and BL1 914) and can share a reference line (e.g., Vref 916), which allows different data to be stored in the two storage circuits.

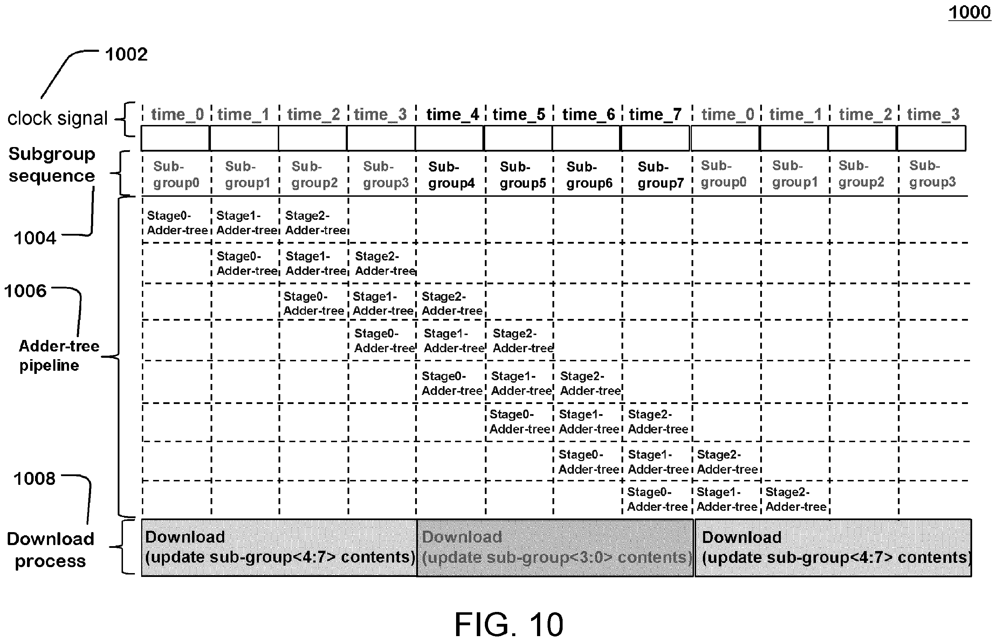

Fig. 10 illustrates an operational time sequence of subgroup 0 903 through subgroup_7 910 of Fig. 9. Fig. 10 identifies subgroup_0 903 as "sub-group0", identifies subgroup_1 904 as "sub-group 1," and so on.

Specifically, Fig. 10 illustrates a chart 1000 that includes a time sequence of cycling from time_0 to time_7, and then starting back at time_0. The uppermost part of the time sequence identifies the clock signals 1002. Below the corresponding time sequences of clock signals 1002, the chart 1000 illustrates a subgroup sequence 1004, indicating which subgroup is performing and/or outputting the mathematical operations. Below the subgroup sequence 1004 the chart 1000 illustrates an adder tree pipeline 1006, which indicates which stage of the adder tree is active. Since Fig. 9 illustrates 128 outputs, an adder tree 600 of Fig. 6 can be implemented, such that it has 3 stages, the first stage (stage 0) includes receiving inputs and storing results in the buffer latches 610, the second stage (stage 1) includes processing data from buffer latches 610 and storing results in buffer latches 612 and the third stage (stage 2) includes processing data from buffer latches 612 and providing the single output to path 628.

As illustrated, the adder-tree pipeline 1006 indicates which stages of the adder tree 600 are processing inputs/data. Further, the chart illustrates the download process 1008 of downloading contents, which includes writing contents to the storage circuits of the various subgroups. For example, from time_0 to time_3, content is downloaded and written to the storage circuits of subgroups 4, 5, 6 and 7, while subgroups 0, 1, 2 and 3 are performing multiply and/or output operations. Similarly, from time_4 to time_7, content is downloaded and written to the storage circuits of subgroups 0, 1, 2 and 3, while subgroups 4, 5, 6 and 7 are performing multiply and/or output operations. Then again, from time_0 to time_3, new content is downloaded and written to the storage circuits of subgroups 4, 5, 6 and 7, while subgroups 0, 1, 2 and 3 are performing multiply and/or output operations using content that was written during times 4 through_7. Downloading and writing time can take more than one clock cycle. As such, an advantage of the dCIM system 900 of Fig. 9 is that there are four clock cycles available for writing contents to a particular set of subgroups (in this example, a set of subgroups includes four subgroups). This structure reduces or eliminates time spent waiting for the writing of contents to finish before starting multiply and/or output operations.

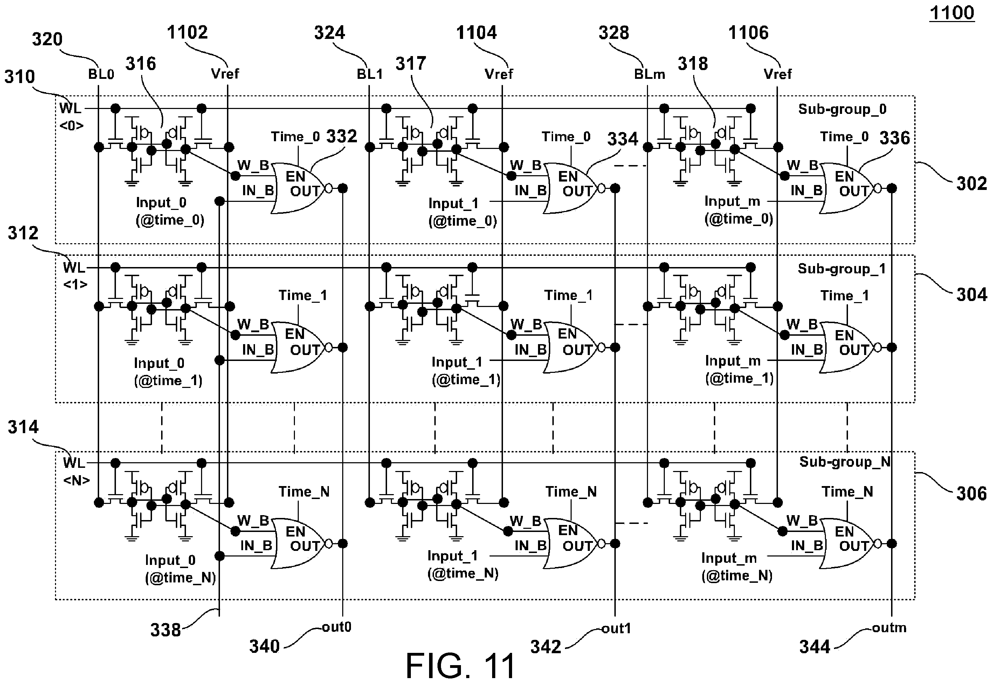

Fig. 11 illustrates an dCIM system in which contents are written using a bit line and a reference voltage (Vref).

Specifically, Fig. 11 illustrates a similar dCIM system 1100 as described with reference to Fig. 5 and redundant descriptions are omitted herewith. The dCIM system 1100 is different from the dCIM system 500 of Fig. 5 in that bit line bar lines are replaced with Vref lines. Specifically, Fig. 11 illustrates Vref lines 1102, 1104 and 1106 being connected to the storage circuits for writing thereto. Replacing the bit line bar lines with Vref provides an advantage in that a number of SA-latches (sense amplifier and latch) can be doubled, so as to increase the sensing speed, by double. For example, if there are 1024 memory-BL in the memory array, the 1024 memory-BL divided into 512 SRAM-BL and 512 SRAM-BLB, this way it can only sense 512 bits data once. If there are 1024 memory BL connected to 1024 SRAM BL and 1024 BLB connected to Vref, then 1024 bits of data can be sensed at once.

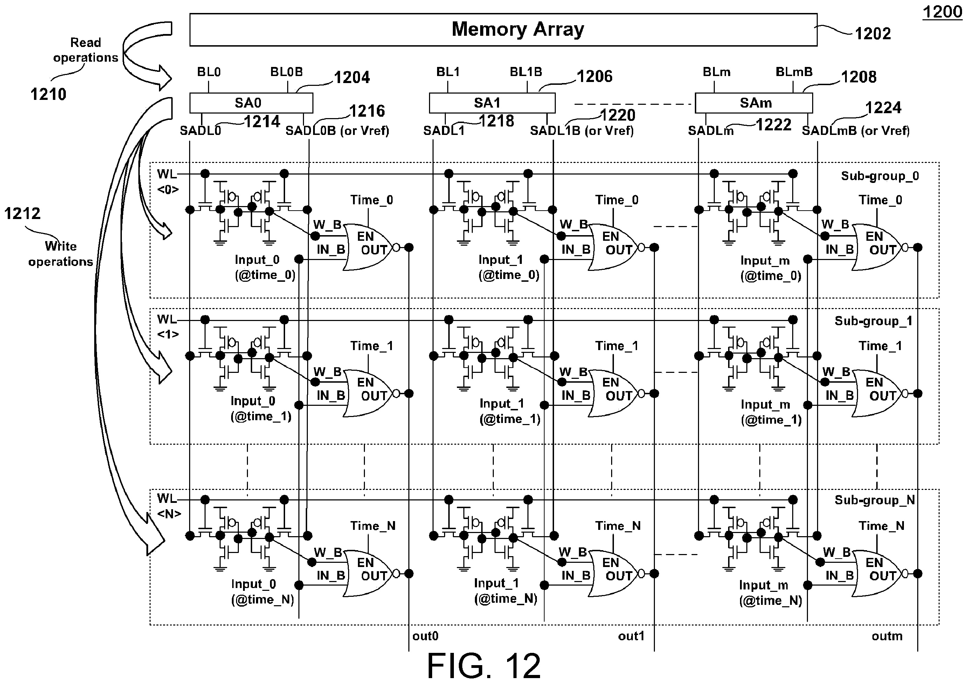

Fig. 12 illustrates an dCIM system in which contents are written using sense amplifiers.

Specifically, Fig. 12 illustrates a similar dCIM system 1200 as described with reference to Fig. 5 and redundant descriptions are omitted herewith. Fig. 12 illustrates a memory array 1202 that stores contents, wherein read operations 1210 are performed to read the contents from the memory array 1202 into sense amplifiers SA0 1204, SA1 1206 and SAm 1208 via respective bit lines and bit line bar lines BL0, BLOB, BL1, BL1B, BLm and BLmB. As previously described, the memory array 1200 that stores contents (data elements) can be any type of NVM and volatile memory. The dCIM system 1200 of Fig. 12 is different from the dCIM system 500 of Fig. 5 in that it includes the sense amplifiers to provide contents to the various subgroups. As illustrated, write operations 1212 are performed to write the content from the sense amplifiers to the storage circuits of the various subgroups. Specifically, sense amplifier SA0 1206 provides contents on SA DL0 line 1214 and SA DL0B line 1216 to write the contents to certain storage circuits, sense amplifier SA1 1206 provides contents on SA DL1 line 1218 and SA DL1B line 1220 to write the contents to certain storage circuits and sense amplifier Sam 1208 provides contents on SA DLm line 1222 and SA DLmB line 1224 to write the contents to certain storage circuits. Alternatively, rather than using bar lines (i.e., SA DL0B line 1216, SA DL1B line 1220, and SA DLmB line 1224) to write the contents, the contents can be written using Vref. Using the sense amplifiers, as opposed to programming the storage circuits directly from the bit lines and bit line bar lines, allows for faster programming as the sense amplifiers can provide higher voltage signals that what can be provided on bit lines and bit line bar lines.

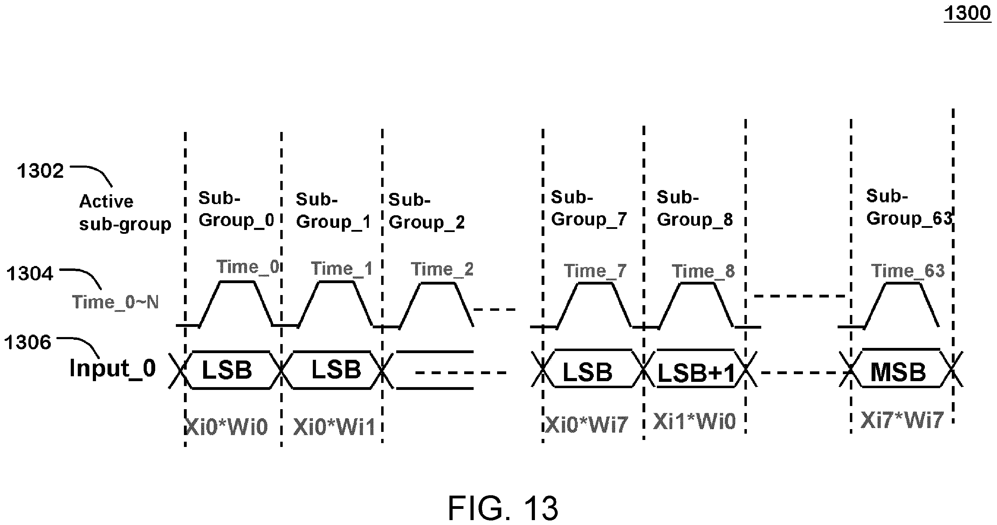

Fig. 13 illustrates a timing chart of performing MAC operations using the dCIM system 500 of Fig. 5.

Specifically, the timing chart 1300 illustrates that inputs can remain stationary until they are multiplied by all weights. For example, Fig. 13 illustrates active subgroups 1302, a time sequence 1304 of time_0 through time_N and an input sequence 1306 of input 0 338 of the dCIM system 500 of Fig. 5. This timing chart can be modified to accommodate other dCIM systems described herein.

As illustrated, with respect to Fig. 5, N=64, such that there are 64 subgroups. The active subgroups 1302 illustrates proceeding through the subgroups in order in accordance with the time sequence. The input sequence 1306 on input_0 338 remains the same (Xi0) and is multiplied by each of weights Wi0, Wi1 Wi2, Wi3, Wi4, Wi5, Wi6 and Wi7 from time_0 to time_7. Then at time 8 the input is changed to Xi1, which is multiplied by each of weights Wi0, Wi1 Wi2, Wi3, Wi4, Wi5, Wi6 and Wi7 from time_8 to time_15. This process continues until input Xi7 is multiplied by weight Wi7 at time_63. As described herein, while subgroups connected to a particular word line are performing the multiplication and/or output operations, the weights of other subgroups connected to other word lines can be updated. This sequence of operations illustrated in Fig. 13 can be referred to as "input stationary and sequential serial input in product operation".

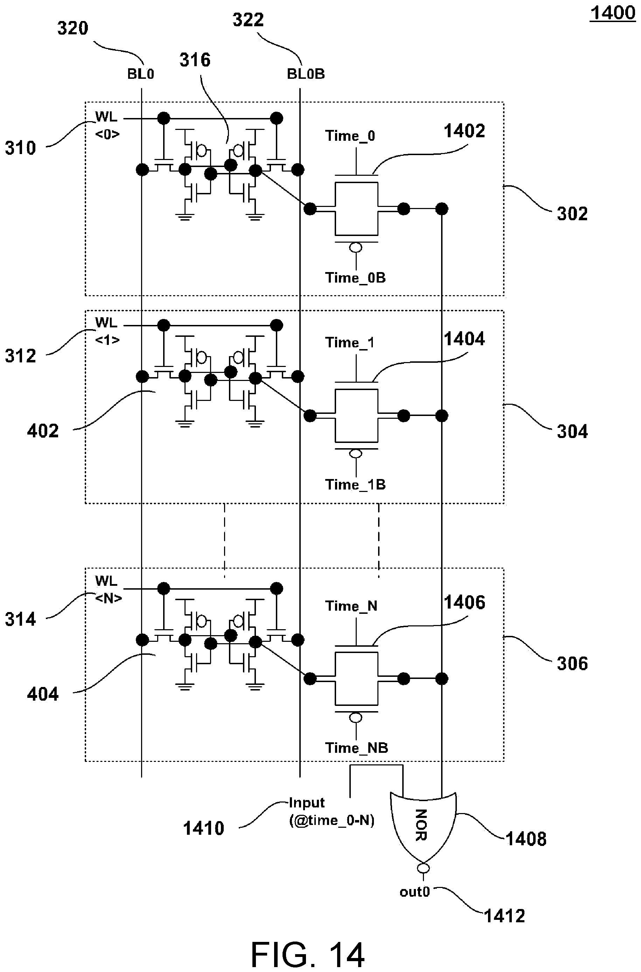

Fig. 14 illustrates an dCIM system that uses pass gates rather than the tri-state NOR gates illustrated in Fig. 3.

Specifically, Fig. 14 illustrates a structure 1400 in which is similar to that of Fig. 4 and redundant descriptions thereof are omitted. However, the structure 1400 replaces the tri-state NOR gates 332, 406 and 408 of Fig.

4 with pass gates 1402, 1404 and 1406. Just like Fig. 4, there can be N pass gates for each subgroup. At time 0 (at receiving time signals Time_0 and Time_0B), pass gate 1402 allows the content stored in storage circuits 316 to pass to NOR gate 1408 which multiplies the content stored in storage circuits 316 by an input 1410 provided thereto at time_0. There can be N NOR gates in the structure 1400, where each of the N NOR gates corresponds to a particular column of pass gates. The NOR gate 1408 provides output out0 1412 to an adder tree (accumulator). At time_1 (at receiving time signals Time_1 and Time_1B), pass gate 1404 allows the content stored in storage circuits 402 to pass to NOR gate 1408 which multiplies the content stored in storage circuits 402 by an input 1410 provided thereto at time_1. At time N (at receiving time signals Time N and Time NB), pass gate 1406 allows the content stored in storage circuits 404 to pass to NOR gate 1408 which multiplies the content stored in storage circuits 404 by an input 1410 provided thereto at time_N. This implementation eliminates the need for and space occupied by the tri-state NOR gates.

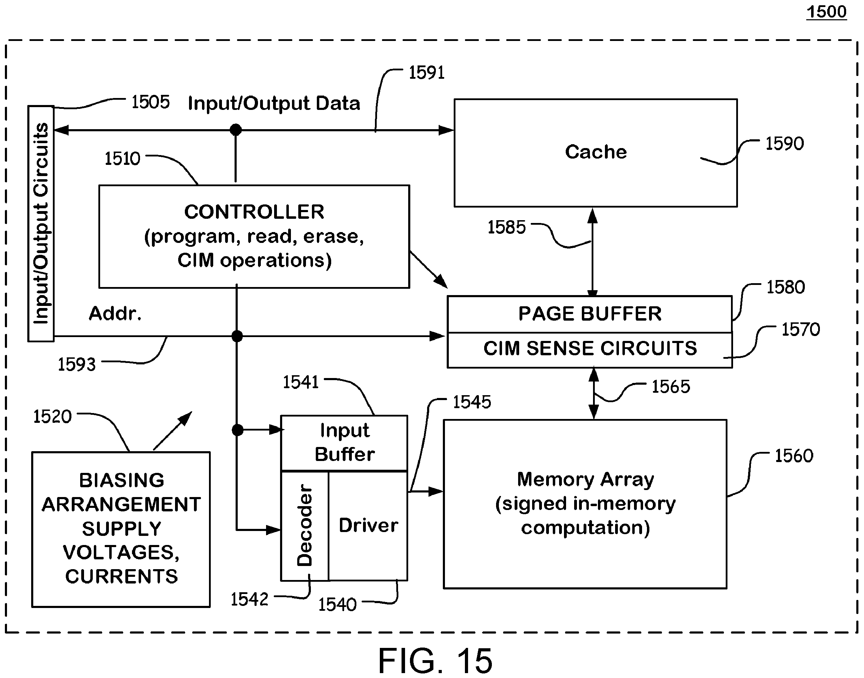

Fig. 15 illustrates a simplified block diagram of an integrated circuit device including a memory array arranged for in-memory computation with signed (or unsigned) inputs and weights.

Specifically, Fig. 15 illustrates an integrated circuit device 1500 including a memory array 1560 arranged for signed, in-memory computation for a CIM operation, such as a signed (or unsigned), sum-of-products (MAC) operation, as performed by the dCIM system described herein. The integrated circuit device 1500 can be implemented on a single chip, or on a multichip module.

The device 1500 includes input/output circuits 1505 for communication of control signals, data, addresses and commands with other data processing resources, such as a CPU or memory controller.

Input/output data is applied on bus 1591 to a controller 1510, and to cache 1590. Also, addresses are applied on bus 1593 to a decoder 1542, and to the controller 1510. Also, the bus 1591 and bus 1593 can be operably connected to data sources internal to the integrated circuit device 1500, such as a general purpose processor or special purpose application circuitry, or a combination of modules providing for example, system-on-a-chip functionality.

The memory array 1560 can include an array of memory cells in a NOR architecture or in an AND architecture, such that memory cells are arranged in columns along bit lines and in rows along word lines, and the memory cells in a given column are connected in parallel between a bit line and a source reference. The source reference can comprise a ground terminal or a source line connected to source side biasing resources. The memory cells can comprise charge trapping transistors cells, arranged in a 3D structure. The memory array 1560 with in-memory (or near memory) computation can be configured and can perform operations as described above with respect to Figs. 3-14.

The bit lines can be connected by block select circuits to global bit lines 1565, configured for selectable connection to a page buffer 1580, and to CIM sense circuits 1570.

The page buffer 1580 in the illustrated embodiment is connected by bus 1585 to the cache 1590. The page buffer 1580 includes storage elements (which can be various types of memory arrays) and sensing circuits for memory operations, including read and write operations. For flash memory including dielectric charge trapping memory and floating gate charge trapping memory, write operations include program and erase operations.

A driver circuit 1540 is coupled to word lines 1545 in the memory array 1560, and applies word line voltages to selected word lines in response to a decoder 1542 which decodes addresses on bus 1593, or in a computation operation, in response to input data stored in input buffer 1541.

The controller 1510 is coupled to the cache 1590 and the memory array 1560, and to other peripheral circuits used in memory access and in memory computation operations.

Controller 1510, using a for example a state machine, controls the application of supply voltages and currents generated or provided through the voltage supply or current sources in block 1520, for memory operations and for CIM operations.

The controller 1510 includes control and status registers, and control logic which can be implemented using special-purpose logic circuitry including state machines and combinational logic as known in the art. In alternative embodiments, the control logic comprises a general-purpose processor, which can be implemented on the same integrated circuit, which executes a computer program to control the operations of the device. In yet other embodiments, a combination of special-purpose logic circuitry and a general-purpose processor can be utilized for implementation of the control logic.

The array 1560 includes memory cells arranged in columns and rows, where memory cells in columns are connected to corresponding bit lines, and memory cells in rows are connected to corresponding word lines. The array 1560 is programmable to store signed coefficients (weights Wi) in sets of memory cells.

In a CIM mode, the word line driver circuit 1540 or a driver circuit 1540 can include drivers (referred to as input drivers or input activation drivers) configured to drive signed or unsigned inputs Xi from the input buffer 1541. Driver circuit 1540 can be separate from a word line driver circuit. The CIM sense circuits 1570 are configured to sense differences between first and second currents on respective bit lines in selected pairs of bit lines and to produce outputs for the selected pairs of bit lines as a function of the difference. The outputs can be applied to storage elements in the page buffer 1580 and to the cache 1590.

In an embodiment, the first subgroup can include first storage circuits and first multiplication circuits, wherein the first storage circuits are connected to the first word line and are programmable to store the first set of weights and wherein the first multiplication circuits are enabled by the first timing signal to multiply the first set of weights by inputs to provide the first outputs, wherein the second subgroup includes second storage circuits and second multiplication circuits, wherein the second storage circuits are connected to the second word line and are programmable to store the second set of weights and wherein the second multiplication circuits are enabled by the second timing signal to multiply the second set of weights by inputs to provide the second outputs, the second multiplication circuits being enabled at a time that is different from a time at which the first multiplication circuits are enabled, and wherein the accumulation circuitry receives and accumulates (i) the first outputs in dependence on the first multiplication circuits being enabled by the first timing signal and (ii) the second outputs in dependence on the second multiplication circuits being enabled by the second timing signal.

In an embodiment, the compute-in-memory circuit can include a first output line and a second output line, wherein the first output line is shared by an output of one multiplication circuit of the first multiplication circuits of the first subgroup and an output of one multiplication circuit of the second multiplication circuits of the second subgroup, wherein the second output line is shared by an output of another multiplication circuit of the first multiplication circuits of the first subgroup and an output of another multiplication circuit of the second multiplication circuits of the second subgroup, wherein the first outputs of the first subgroup are provided to the accumulation circuitry via the first and second output lines in dependence upon the first multiplication circuits being enabled without the second multiplication circuits being enabled, and wherein the second outputs of the second subgroup are provided to the accumulation circuitry via the first and second output lines in dependence upon the second multiplication circuits being enabled without the first multiplication circuits being enabled.

In a further embodiment, a particular storage circuit of the first storage circuits of the first subgroup and a particular storage circuit of the second storage circuits of the second subgroup can share common programming lines for controlling storing of respective weights, wherein the particular storage circuit of the first subgroup is programmed to store a particular weight of the first set of weights in dependence on the first word line activating the first subgroup, and wherein the particular storage circuit of the second subgroup is programmed to store a particular weight of the second set of weights in dependence on the second word line activating the second subgroup.

In an embodiment, a compute-in-memory circuit can include multiplication circuits configured to receive and multiply inputs and to provide outputs, a first subgroup of circuits connected to a first word line and configured to (i) store a first set of weights and (ii) prove, in dependence on a first timing signal enabling first pass gates, the first set of weights to the multiplication circuits, a second subgroup of circuits connected to a second word line and configured to (i) store a second set of weights and (ii) provide, in dependence on a second timing signal enabling second pass gates, the second set of weights to the multiplication circuits, the providing of the second set of weights being enabled at a time that is different from a time at which the providing of the first set of weights is enabled, and accumulation circuitry shared by the first subgroup and the second subgroup and configured to receive and accumulate (i) first outputs received from the multiplication circuits in dependence on the first pass gates being enabled by the first timing signal and (ii) second outputs received from the multiplication circuits in dependence on the second pass gates being enabled by the second timing signal.

An implementation of a memory array can be based on charge trapping memory cells, such as floating gate memory cells which can include polysilicon charge trapping layers, or dielectric charge trapping memory cells which can include silicon nitride charge trapping layers. Other types of memory technology can be applied in various embodiments of the technology described herein.

Other implementations of the method described in this section can include a non-transitory computer readable storage medium storing instructions executable by a processor to perform any of the methods described above. Yet another implementation of the method described in this section can include a system including memory and one or more processors operable to execute instructions, stored in the memory, to perform any of the methods described above.

Any data structures and code described or referenced above are stored according to many implementations on a computer-readable storage medium, which may be any device or medium that can store code and/or data for use by a computer system. This includes, but is not limited to, volatile memory, non-volatile memory, application-specific integrated circuits (ASICs), field-programmable gate arrays (FPGAs), magnetic and optical storage devices such as disk drives, magnetic tape, CDs (compact discs), DVDs (digital versatile discs or digital video discs), or other media capable of storing computer-readable media now known or later developed.

An example of a processor is a hardware unit (e.g., comprising hardware circuitry such as one or more active devices) enabled to execute program code. Processors optionally comprise one or more controllers and/or state machines. Processors are implementable according to Application Specific Integrated Circuit (ASIC), Field-Programmable Gate Array (FPGA), and/or custom design techniques. Processors are manufacturable according to integrated circuit, optical, and quantum technologies. Processors use one or more architectural techniques such as sequential (e.g., Von Neumann) processing, Very Long Instruction Word (VLIW) processing. Processors use one or more microarchitectural techniques such as executing instructions one-at-a-time or in parallel, such as via one or more pipelines. Processors are directed to general purpose uses (and/or) special purpose uses (such as signal, audio, video, and/or graphics uses). Processors are fixed function or variable function such as according to programming. Processors comprise any one or more of registers, memories, logical units, arithmetic units, and graphics units. The term processor is meant to include processor in the singular as well as processors in the plural, such as multi-processors and/or clusters of processors.

The logic described herein can be implemented using processors programmed using computer programs stored in memory accessible to the computer systems and executable by the processors, by dedicated logic hardware, including field programmable integrated circuits, and by combinations of dedicated logic hardware and computer programs. With all flowcharts herein, it will be appreciated that many of the steps can be combined, performed in parallel or performed in a different sequence without affecting the functions achieved. In some cases, as the reader will appreciate, a re-arrangement of steps will achieve the same results only if certain other changes are made as well. In other cases, as the reader will appreciate, a re-arrangement of steps will achieve the same results only if certain conditions are satisfied. Furthermore, it will be appreciated that the flow charts herein show only steps that are pertinent to an understanding of the invention, and it will be understood that numerous additional steps for accomplishing other functions can be performed before, after and between those shown.

**Claims**

1.    A compute-in-memory circuit, **characterized in** comprising:

one or more input lines receiving M input data elements, M being an integer greater than zero; an array of memory cells including one or more subgroups, each subgroup of the one or more subgroups storing M stored data elements; multiplier circuits connected to the array of memory cells and to the one or more input lines, and configured to multiply the M input data elements by the M stored data elements in a selected subgroup of the one or more subgroups and to provide a multiplier output having M data elements; and accumulation circuitry including an accumulator input of M data elements connected to the multiplier output and configured to generate a sum of the M data elements of the multiplier output, wherein the multiplier circuits supply a multiplication result to the multiplier output from the one or more subgroups.

2. The compute-in-memory circuit of claim 1, **characterized in that** the multiplier circuits include, for each subgroup of the one or more subgroups, M tri-state multipliers connected to the multiplier output.

3. The compute-in-memory circuit of claim 2, **characterized in that** the M tri-state multipliers are M tri-state NOR gates.

4. The compute-in-memory circuit of claim 2, **characterized in that**

the one or more subgroups includes a first subgroup storing M stored data elements and a second subgroup storing M stored data elements,

the M tri-state multipliers for the first subgroup are enabled by a first timing signal to multiply the M input data elements by the M stored data elements of the first subgroup, and

the M tri-state multipliers for the second subgroup are enabled by a second timing signal to multiply the M input data elements by the M stored data elements of the second subgroup, such that the M tri-state multipliers for the second subgroup are enabled at a time that is different than the M tri-state multipliers for the first subgroup, the second timing signal being provided at a time that is different than the first timing signal.

5. The compute-in-memory circuit of claim 2, **characterized in that**

the one or more subgroups includes a first subgroup storing M stored data elements in M storage circuits and a second subgroup storing M stored data elements in M storage circuits,

the first subgroup is connected to a first word line, and

the second subgroup is connected to a second word line.

6. The compute-in-memory circuit of claim 5, **characterized in that**

a particular storage circuit of the M storage circuits of the first subgroup and a particular storage circuit of the M storage circuits of the second subgroup share common lines for controlling storing of respective data elements,

the particular storage circuit of the first subgroup stores a particular data element in dependence on the first word line activating the first subgroup, and

the particular storage circuit of the second subgroup stores a particular data element in dependence on the second word line activating the second subgroup.

7. The compute-in-memory circuit of claim 6, **characterized in that** the common lines shared by the particular storage circuit of the first subgroup and the particular storage circuit of the second subgroup include a bit line (BL).

8. The compute-in-memory circuit of claim 5, **characterized in that** a particular storage circuit of the M storage circuits of the second subgroup has a particular data element written thereto while, at least one of, (i) the M tri-state multipliers for the first subgroup are enabled by a first timing signal to multiply the M input data elements by the M stored data elements of the first subgroup to provide the multiplier output having M data elements and (ii) the accumulation circuitry receives and accumulates the multiplier output having M data elements.

9. The compute-in-memory circuit of claim 5, **characterized in that**

the multiplier output includes a first output line and a second output line,

the first output line is shared by an output of one tri-state multiplier for the first subgroup and an output of one tri-state multiplier for the second subgroup,

the second output line is shared by an output of another tri-state multiplier for the first subgroup and an output of another tri-state multiplier for the second subgroup,

outputs associated with the first subgroup are provided to the accumulation circuitry via the first and second output lines in dependence upon the M tri-state multipliers for the first subgroup being enabled by timing control signals without the M tri-state multipliers for the second subgroup being enabled by the timing control signals, and

outputs associated with the second subgroup are provided to the accumulation circuitry via the first and second output lines in dependence upon the M tri-state multipliers for the second subgroup being enabled by the timing control signals without the M tri-state multipliers for the first subgroup being enabled by the timing control signals.

10. The compute-in-memory circuit of claim 2, **characterized in that**

the one or more subgroups includes a first subgroup storing M stored data elements, a second subgroup storing M stored data elements, a third subgroup storing M stored data elements and a fourth subgroup storing M stored data elements, the first subgroup and the second subgroup are connected to a first word line,

the third subgroup and the fourth subgroup are connected to a second word line,

the M tri-state multipliers for the first subgroup are enabled by a first timing signal to multiply the M input data elements by the M stored data elements of the first subgroup,

the M tri-state multipliers for the second subgroup are enabled by a second timing signal to multiply the M input data elements by the M stored data elements of the second subgroup,

the M tri-state multipliers for the third subgroup are enabled by a third timing signal to multiply the M input data elements by the M stored data elements of the third subgroup,

the M tri-state multipliers for the fourth subgroup are enabled by a fourth timing signal to multiply the M input data elements by the M stored data elements of the fourth subgroup, and

L is an integer that represents a total number of the M stored data elements of the first subgroup and M stored data elements of the second subgroup and wherein M = L/2.

11. The compute-in-memory circuit of claim 10, **characterized in that**

the multiplier output includes a first output line, and

the first output line is shared by an output of one tri-state multiplier for the first subgroup, an output of one tri-state multiplier for the second subgroup, an output of one tri-state multiplier for the third subgroup and an output of one tri-state multiplier for the fourth subgroup.

12. The compute-in-memory circuit of claim 11, **characterized in that**

the multiplier output includes a second output line, and

the second output line is shared by an output of another tri-state multiplier for the first subgroup, an output of another tri-state multiplier for the second subgroup, an output of another tri-state multiplier for the third subgroup and an output of another tri-state multiplier for the fourth subgroup.

13. The compute-in-memory circuit of claim 1, **characterized in that** the M stored elements of each respective subgroup of the one or more subgroups are written to each respective subgroup using bit lines.

14. The compute-in-memory circuit of claim 1, **characterized in that** the M stored elements of each respective subgroup of the one or more subgroups are written to each respective subgroup using sense amplifiers connected to bit lines.

15. The compute-in-memory circuit of claim 1, **characterized in that**

the one or more subgroups includes a first subgroup storing M stored data elements and a second subgroup storing M stored data elements,

during a first clock cycle, the first subgroup multiplies the M stored data elements by the M input data elements and the second subgroup has the M stored elements written thereto, and

during a second clock cycle, the second subgroup multiplies the M stored data elements by the M input data elements and the first subgroup has the M stored elements written thereto.

16. The compute-in-memory circuit of claim 1, **characterized in that**

the one or more subgroups includes a first subgroup storing M stored data elements and a second subgroup storing M stored data elements,

during a particular clock cycle, the accumulation circuitry accumulates outputs associated with the first subgroup, and

during a subsequent clock cycle, the accumulation circuitry accumulates outputs associated with the second subgroup.

17. The compute-in-memory circuit of claim 16, **characterized in that** the accumulation circuitry is pipelined.

18. The compute-in-memory circuit of claim 1, **characterized in that** the multiplier circuits include, for each subgroup of the one or more subgroups, M pass gates connected to a shared M bit multiplier connected to the multiplier output.

19. The compute-in-memory circuit of claim 1, **characterized in that** the multiplier circuits are enabled by timing control signals to supply the multiplication result.

20. The compute-in-memory circuit of claim 19, **characterized in that** the timing control signals include a first timing signal and a second timing signal, such that the first timing signal is provided at a time that is different than the second timing signal.

21. The compute-in-memory circuit of claim 7, **charac-**

**terized in that** the common lines further include a bit line bar line (BLB).

22. The compute-in-memory circuit of claim 7, **characterized in that** the common lines further include a reference voltage line (Vref).

23. The compute-in-memory circuit of claim 1, **characterized in that** the array of memory cells includes latches.

24. A method of performing operations using a compute-in-memory circuit including (i) an array of memory cells including a one or more subgroups, each subgroup of the one or more subgroups storing M stored data elements, M being an integer greater than zero, (ii) multiplier circuits connected to the array of memory cells and to one or more input lines, and (iii) accumulation circuitry including an accumulator input of M data elements connected to a multiplier output, **characterized in that** the method comprises:

    obtaining M input data elements from the one or more input lines,
    multiplying, by the multiplier circuits, the M input data elements by the M stored data elements in a selected subgroup of the one or more subgroups to provide a multiplier output having M data elements wherein the multiplier circuits are enabled by timing control signals to supply a multiplication result to the multiplier output from the one or more subgroups in sequence; and
    generating, by the accumulation circuitry, a sum of the M data elements of the multiplier output.

25. A compute-in-memory circuit, **characterized in** comprising:

    a first subgroup of circuits connected to a first word line and configured to store a first set of weights;
    a second subgroup of circuits connected to a second word line and configured to store a second set of weights;
    multiplier circuits configured to (i) multiply, in dependence on a first timing signal, the first set of weights by inputs, (ii) provide first outputs, (iii) multiply, in dependence on a second timing signal, the second set of weights by inputs and (iv) provide second outputs, wherein multiplying of the second set of weights is enabled at a time that is different from a time at which multiplying of the first set of weights is enabled; and
    accumulation circuitry shared by the first subgroup and the second subgroup and configured to receive and accumulate (i) the first outputs in dependence on the multiplying of the first set of weights being enabled by the first timing signal and (ii) the second outputs in dependence on the multiplying of the second set of weights being enabled by the second timing signal.

100

FIG. 1

FIG. 2

FIG. 3

EP 4 579 438 A1

FIG. 4

FIG. 5

EP 4 579 438 A1

FIG. 6

EP 4 579 438 A1

FIG. 7

EP 4 579 438 A1

FIG. 8

FIG. 9

1000

**clock signal** — 1002

| | time_0 | time_1 | time_2 | time_3 | time_4 | time_5 | time_6 | time_7 | time_0 | time_1 | time_2 | time_3 |
|---|---|---|---|---|---|---|---|---|---|---|---|---|
| **Subgroup sequence** (1004) | Sub-group0 | Sub-group1 | Sub-group2 | Sub-group3 | Sub-group4 | Sub-group5 | Sub-group6 | Sub-group7 | Sub-group0 | Sub-group1 | Sub-group2 | Sub-group3 |
| **Adder-tree pipeline** (1006) | Stage0-Adder-tree | Stage1-Adder-tree | Stage2-Adder-tree | | | | | | | | | |
| | | Stage0-Adder-tree | Stage1-Adder-tree | Stage2-Adder-tree | | | | | | | | |
| | | | Stage0-Adder-tree | Stage1-Adder-tree | Stage2-Adder-tree | | | | | | | |
| | | | | Stage0-Adder-tree | Stage1-Adder-tree | Stage2-Adder-tree | | | | | | |
| | | | | | Stage0-Adder-tree | Stage1-Adder-tree | Stage2-Adder-tree | | | | | |
| | | | | | | Stage0-Adder-tree | Stage1-Adder-tree | Stage2-Adder-tree | | | | |
| | | | | | | | Stage0-Adder-tree | Stage1-Adder-tree | Stage2-Adder-tree | | | |
| | | | | | | | | Stage0-Adder-tree | Stage1-Adder-tree | Stage2-Adder-tree | | |
| **Download process** (1008) | Download (update sub-group<4:7> contents) | | | | Download (update sub-group<3:0> contents) | | | | Download (update sub-group<4:7> contents) | | | |

EP 4 579 438 A1

FIG. 10

FIG. 11

EP 4 579 438 A1

FIG. 12

1300

FIG. 13

1302 — Active sub-group

1304 — Time_0~N

1306 — Input_0

| Sub-Group_0 | Sub-Group_1 | Sub-Group_2 | | Sub-Group_7 | Sub-Group_8 | | Sub-Group_63 |
| Time_0 | Time_1 | Time_2 | | Time_7 | Time_8 | | Time_63 |
| LSB | LSB | | | LSB | LSB+1 | | MSB |
| $Xi0*Wi0$ | $Xi0*Wi1$ | | | $Xi0*Wi7$ | $Xi1*Wi0$ | | $Xi7*Wi7$ |

31

1400

320    322    1400

BL0    316    BL0B

WL
<0>

1402

310    Time_0

302

Time_0B

WL
<1>

1404

312

402    Time_1    304

Time_1B

WL
<N>

1406

314    Time_N

306

404    Time_NB

Input
(@time_0-N)

1410    NOR    1408

out0    1412

FIG. 14

FIG. 15

Europäisches
Patentamt
European
Patent Office
Office européen
des brevets

# EUROPEAN SEARCH REPORT

Application Number

EP 24 19 8624

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/244916 A1 (LEE PO-HAO [TW] ET AL) 4 August 2022 (2022-08-04) * paragraph [0026] - paragraph [0048]; figure 7 * ----- | 1-25 | INV. G06F7/544 |
| A | US 2022/375508 A1 (CHANG YEN-AN [TW] ET AL) 24 November 2022 (2022-11-24) * paragraph [0025] - paragraph [0048]; figures 1, 2 * ----- | 1-25 | |
| A | US 2023/259330 A1 (MORI HARUKI [TW] ET AL) 17 August 2023 (2023-08-17) * paragraph [0036] - paragraph [0087] * ----- | 1-25 | |

TECHNICAL FIELDS
SEARCHED        (IPC)

G06F

The present search report has been drawn up for all claims

| Place of search | Date of completion of the search | Examiner |
|---|---|---|
| Munich | 17 February 2025 | Tenbieg, Christoph |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 19 8624

This annex lists the patent family members relating to the patent documents cited in the above-mentioned European search report.
The members are as contained in the European Patent Office EDP file on
The European Patent Office is in no way liable for these particulars which are merely given for the purpose of information.

17-02-2025

| Patent document cited in search report | Publication date | Patent family member(s) | | Publication date |
|---|---|---|---|---|
| US 2022244916 A1 | 04-08-2022 | CN | 114613404 A | 10-06-2022 |
| | | DE | 102021120080 A1 | 04-08-2022 |
| | | KR | 20220110090 A | 05-08-2022 |
| | | TW | 202230165 A | 01-08-2022 |
| | | US | 2022244916 A1 | 04-08-2022 |
| | | US | 2024385803 A1 | 21-11-2024 |
| US 2022375508 A1 | 24-11-2022 | CN | 115148234 A | 04-10-2022 |
| | | DE | 102022100200 A1 | 24-11-2022 |
| | | KR | 20220157868 A | 29-11-2022 |
| | | TW | 202309737 A | 01-03-2023 |
| | | US | 2022375508 A1 | 24-11-2022 |
| | | US | 2024347101 A1 | 17-10-2024 |
| US 2023259330 A1 | 17-08-2023 | CN | 116243884 A | 09-06-2023 |
| | | DE | 102023100012 A1 | 17-08-2023 |
| | | KR | 20230121529 A | 18-08-2023 |
| | | TW | 202333044 A | 16-08-2023 |
| | | US | 2023259330 A1 | 17-08-2023 |

EPO FORM P0459

For more details about this annex : see Official Journal of the European Patent Office, No. 12/82